# FASCICULE DE BREVET EUROPEEN

(11) **EP 4 189 406 B1**
(45) Date de publication et mention de la délivrance du brevet: **04.09.2024**
(21) Numéro de dépôt: 21751779.6
(22) Date de dépôt: 23.07.2021
(51) Int. Cl.: G01R 19/165, G01R 31/392

(54) **SYSTÈME DE GESTION DE BATTERIES**
BATTERIEVERWALTUNGSSYSTEM
BATTERY MANAGEMENT SYSTEM

(30) Priorité: 27.07.2020 FR 2007923
(43) Date de publication de la demande: 07.06.2023
(73) Titulaire: Limatech, 31300 Toulouse (FR)
(72) Inventeur: POUYADOU, Luc, 31190 BRIGNOUD (FR); DI MEGLIO, Maxime, 31650 SAINT ORENS (FR); ROBIN, Florence, 31650 SAINT ORENS (FR)
(74) Mandataire: AtlantIP International
(86) Numéro de dépôt international: PCT/EP2021/070674
(87) Numéro de publication internationale: WO 2022/023204

(56) Documents cités:
- WO-A1-00/76012
- WO-A1-2007/086971
- WO-A1-2007/140955
- US-A1- 2019 302 190

## Description

### DOMAINE TECHNIQUE DE L'INVENTION

[La présente invention concerne le domaine des batteries d'accumulateurs au lithium et en particulier la sécurisation desdites batteries.

### ETAT DE LA TECHNIQUE ANTERIEURE

Les batteries d'accumulateurs sont constituées d'éléments électrochimiques qui peuvent être connecté en série ou en parallèle pour obtenir la tension et le courant nécessaire.

Les batteries existantes, par exemple et de manière non limitative celles destinées au domaine de l'aviation, au Plomb ou au Nickel-Cadmium, présentent une masse élevée, une faible durée de vie, une importante autodécharge et nécessitent une maintenance régulière. Cependant, du fait de leur faible densité d'énergie, elles présentent peu de risque de surchauffe et de feu. Souvent, un fusible ou un disjoncteur est suffisant pour assurer la protection en court-circuit.

En cas de court-circuit ou de surintensité, il est nécessaire de déconnecter la batterie pour éviter de l'endommager et éviter un échauffement excessif de la batterie ou de ses câbles de connexion.

Les batteries au lithium nécessitent également des circuits de protection contre les surintensités et les courts-circuits. Généralement, on utilise des disjoncteurs électromécaniques ou des fusibles, ou des circuits électroniques qui assurent une mesure du courant et pilotent un organe de coupure. Cependant, la mesure d'un courant n'est pas simple.

Il existe plusieurs méthodes de mesures de courant (shunt, mesure magnétique ou par un effet thermique).

On connait notamment le document US 2019/302190 A1 qui décrit un système électronique à faible consommation électrique permettant de mesurer à la fois une mesure de charge d'une batterie, ainsi qu'une détection de surintensité. Le système électronique comprend un circuit de mesure qui mesure une tension de batterie, un circuit d'interface qui transmet des informations de tension de batterie à un dispositif de traitement, et un circuit de commande. Le circuit de mesure comprend un compteur et un pont diviseur de tension placé en parallèle de la batterie et dont le rapport de division est déterminé par une valeur du compteur. Le circuit de mesure comporte aussi un comparateur qui compare une tension de sortie du circuit à résistance avec une tension de référence. Lorsque l'alimentation électrique du dispositif de traitement est coupée, le compteur règle la valeur de comptage sur une valeur fixe, et le circuit de commande effectue met en sécurité la batterie sur la base du résultat de comparaison du comparateur.

On connait aussi le document WO 2007/086971 A1 qui décrit un dispositif de surveillance d'une batterie rechargeable, le dispositif de surveillance comportant au moins un interrupteur d'interruption de courant pour interrompre le courant circulant à travers au moins une cellule associée et une pluralité d'unités de surveillance pour détecter la tension de la cellule. Chaque unité de surveillance est associée à une seule cellule et comprend une unité de tension de référence pour produire une tension seuil de référence définie et une unité de comparaison de tension pour comparer la tension seuil de référence avec une tension de cellule partielle de la cellule associée. L'unité de tension de référence est alimentée électriquement à partir de la tension de la cellule associée, et l'unité de comparaison de tension est couplée à au moins un interrupteur d'interruption de courant pour interrompre le courant circulant à travers la cellule associée.

Néanmoins ces méthodes de mesures peuvent impliquer une consommation élevée, ce qui peut nécessiter de recourir à un mode « veille » et un mode « actif ». De plus, cela est difficilement compatible avec une protection court-circuit, celui-ci pouvant intervenir à tout instant.

En outre, une batterie de démarrage de moteur thermique doit fournir un très fort courant pendant quelques secondes à quelques dizaines de secondes. Aussi, le courant du disjoncteur (organe de coupure) devra être réglé à une valeur assez forte, de l'ordre de la moitié du courant de court-circuit (la puissance maximale fournie par une batterie est atteinte quand la tension vaut la moitié de la tension à vide, et le courant la moitié du courant de court-circuit). Avec le vieillissement, ou pour des températures basses, la résistance interne des éléments de batterie augmente, ainsi le courant de court-circuit diminue. Il est possible que ce courant devienne inférieur au courant de disjonction. Dans ce cas, la protection n'est plus assurée. Un usage dans ces conditions peut entrainer une décharge complète de la batterie dans sa résistance interne, provoquant un fort échauffement, puis un incendie.

Enfin, par exemple et de manière non-limitative, une batterie non modulaire de 17 Ah peut fournir un courant de court-circuit de plus de 2000 A. Ainsi, le dispositif de coupure assurant la disjonction de la batterie de son circuit d'utilisation doit pouvoir supporter ce courant. Des semi-conducteurs pouvant supporter ce courant ne sont pas fréquents et en pratique, plusieurs composants de plus faible courant sont connectés en parallèle. L'équilibre des courants est très difficile à réaliser, ce qui impose de sur-dimensionner les composants. La mesure d'un courant 2000 A pose aussi des problèmes de compromis entre la précision et la consommation statique.

### EXPOSE DE L'INVENTION

La présente invention a pour but de pallier certains inconvénients de l'art antérieur en proposant une méthode de détection de conditions anormales et un système de gestion de batterie lithium, simple fiable, facilement adaptable à des intensités et tensions différentes pour les éléments unitaires ou modulaires.

Un but de l'invention est de permettre que la méthode détecte les conditions de décharge profonde, de court-circuit et de surintensité de batteries Lithium sans passer par une mesure de courant.

Ce but est atteint par un procédé de détection de conditions anormales (décharges profondes, surintensité et court-circuit) de fonctionnement d'un élément unitaire de batterie ou d'une pluralité d'éléments unitaires comportant les étapes suivantes :
Prélèvement, au point commun d'au moins deux résistances d'un pont diviseur à au moins deux résistances, d'au moins une tension proportionnelle à la tension aux bornes de l'élément unitaire ou de l'ensemble d'éléments unitaires ;
comparaison de la tension relevée avec un seuil de référence;
ladite comparaison avec ledit seuil de référence déclenche la mise en oeuvre :
   d'une évaluation de l'évolution à venir par une intégrale, évaluée de façon analogique ou de façon numérique;
   d'une comparaison de cette évaluation avec un seuil Td de tension de détection à partir duquel une disjonction de l'élément unitaire ou de l'ensemble d'éléments unitaires surveillés est effectuée par rapport, au moins, aux bornes de la batterie.

Selon une autre particularité, l'étape d'évaluation par intégrale numérique comporte :
des étapes de calcul de la pente (P) d'évolution de la courbe des tensions par utilisation d'au moins deux mesures prélevées
au moins une étape de comparaison de la pente calculée avec une valeur « Seuilrapide » mémorisée soit, pour appliquer, en cas de dépassement par la pente de la valeur « Seuilrapide », un coefficient de pondération augmentant l'accélération de l'évolution de l'intégrale pour qu'elle franchisse plus vite le seuil Td de tension de déclenchement, soit en cas de non dépassement un coefficient de pondération sans effet d'accélération.

Un autre but est de permettre que le système de gestion surveille les conditions de décharge profonde, de court-circuit et de surintensité de batteries Lithium sans passer par une mesure de courant.

Ce but est atteint par un système de gestion de batteries (BMS) d'accumulateurs, lesdites batteries pouvant être constituées d'un élément unitaire ou de plusieurs éléments unitaires pouvant être arrangés en ensemble modulaire connectés en série, en parallèle ou en pluralité d'ensemble modulaire série associés en parallèle pour constituer une batterie, ledit système comprend des moyens adaptés pour exécuter les étapes d'un procédé de détection selon l'invention.

Selon une autre particularité, le système de gestion de batterie (BMS) comprend au moins :
un pont diviseur de tension à au moins deux résistances, pour le prélèvement d'au moins une tension proportionnelle à la tension aux bornes de l'élément unitaire ou de l'ensemble d'éléments unitaires de la batterie,
un dispositif de détection de conditions anormales,
un dispositif de disjonction,
ledit dispositif de détection communiquant avec le dispositif de disjonction pour l'activer en cas de détection de conditions anormales, ledit dispositif de disjonction étant connectable à la batterie et comportant au moins deux MOSFETs.

Un autre but est de proposer une solution numérique pour un dispositif de détection.

Ce but est atteint par le système de gestion de batteries (BMS) d'accumulateurs selon l'invention, comprenant un microprocesseur équipé d'au moins une mémoire de stockage permettant la mémorisation d'au moins une variable de seuil « Refintégration » et une valeur de tension de détection mémorisée Td, la mémoire contenant également le programme exécuté par le microprocesseur permettant la collecte des points de courbe de tension, les comparaisons et décisions, la mise en oeuvre des équations permettant l'intégration, le microprocesseur recevant en entrée la tension V_{globale} provenant du point commun du pont diviseur entre une résistance R1 et une résistance R2 et mémorise les mesures selon une fréquence déterminée pour observer la courbe de tension V_{globale}, et comparer les valeurs de la courbe de tension V_{globale} à la valeur « Refintégration », puis à partir de la détection du franchissement du seuil « Refintégration » défini par la valeur mémorisée dans la mémoire, déclenche les calculs d'intégration de la courbe V_{globale} et compare les valeurs de la courbe d'intégration (V_{integ}) calculée à une valeur de tension de détection mémorisée Td pour activer le dispositif de disjonction effectuant la coupure.

Selon une autre particularité, la mémoire de stockage du microprocesseur comporte également la valeur d'une variable « Seuilrapide » mémorisée pour déterminer par comparaison de la variation dV de la tension V_{globale} entre deux instants successifs t1 et t2 avec le « Seuilrapide » si le calcul de l'intégrale de la courbe de tension V_{globale} doit prendre en compte ou pas un coefficient de pondération.

Selon une autre particularité, le calcul de l'intégrale comprend la prise en compte de variables « Pente et/ou Ordonnée » calculées par le microprocesseur à partir des données de la courbe de tension V_{globale} enregistrée.

Un autre but est de proposer une solution analogique pour un dispositif de détection.

Cet autre but est atteint par, le système de gestion de batteries (BMS) d'accumulateurs selon l'invention comprenant au moins autour d'un comparateur U1, un pont diviseur (R1, R2, ou R9, R4) monté entre les bornes de l'ensemble modulaire de la batterie ou d'un élément unitaire de la batterie dont le point commun aux résistances est relié à l'entrée de la borne négative du comparateur U1 pour fournir une tension dont la valeur est proportionnelle à la valeur de tension V1 aux bornes de la batterie, dans le rapport défini par les valeurs des deux résistance (R1, R2, ou R9, R4), et de la borne positive du comparateur est reliée à une diode ou une cellule d'alimentation pour définir la tension de référence V2.

Ainsi en changeant les valeurs de résistances et de tension de référence le système pourra s'adapter à des batteries comportant des caractéristiques tension, courant, différentes.

Selon une autre particularité, le montage intégrateur comprend
une résistance R5 branchée entre le point commun du pont diviseur R1, R2 et l'entrée négative du comparateur U1 et, un ensemble résistance R8, condensateur C1, montés en série par une borne commune, branché par l'autre borne de C1 à la sortie du comparateur U1, l'autre borne de R8 étant reliée au point commun aux deux résistances R5, R8 et à l'entrée négative de U1, les valeurs R5 et C1 étant ajustées pour régler le temps d'intervention de la disjonction avant la détérioration de la batterie en cas de détection de surintensité.

Selon une autre particularité, une diode D2 est branchée en parallèle sur la résistance R5, avec sa cathode reliée au point commun du pont diviseur pour changer la constante de temps d'intégration du montage intégrateur dans le cas d'une surintensité ou un court-circuit.

Selon une autre particularité, le comparateur U1 présente à sa borne de sortie une tension dont la valeur caractérise un état « non conducteur » si la tension appliquée à l'entrée de la borne négative de l'amplificateur U1 est supérieure à la valeur de la tension de référence V₂ et par un état «conducteur» si la valeur de la tension appliquée à l'entrée de la borne négative de l'amplificateur U1 est inférieure à la valeur de la tension de référence V₂.

Selon une autre particularité, le dispositif de détection comprend un condensateur C3 monté en parallèle de R2 qui combiné avec R1 forme un filtre pour filtrer des perturbations à haute fréquence.

Selon une autre particularité, en parallèle de R9 est monté
un ensemble série constitué d'une résistance R3, une diode D3 avec cathode orientée vers la borne positive et une diode Zener D4 avec la cathode orientée vers le point commun du pont diviseur R9, R4,
un condensateur C5 reliant le point commun du pont R9, R4 à la borne négative de la batterie ou de la cellule ou de l'ensemble modulaire d'éléments unitaires.

Selon une autre particularité, un circuit comparateur U2 à hystérésis, disposé en aval du circuit comparateur U1, comprend un montage à hystérésis autour de l'amplificateur U2 qui reçoit à l'entrée de sa borne négative la valeur de la tension de la sortie de l'amplificateur U1.

Selon une autre particularité, le comparateur U2 à hystérésis comprend des résistances R3, R4 montées en pont diviseur entre les bornes positives et négatives de la batterie et dont le point commun à R3 et R4 est branché à l'entrée positive du comparateur U2 et dont une résistance R6 relie la sortie de U2 à son entrée positive pour définir le seuil et l'hystérésis du circuit comparateur à hystérésis comportant l'amplificateur U2.

Selon une autre particularité, le dispositif de détection comprend une résistance R7 montée à la borne positive de la batterie, en série avec une diode D1, dans le sens passant en fonctionnement normal, et un condensateur C2 relié d'une part à la cathode de la diode et d'autre part à la borne négative de la batterie pour permettre son chargement pendant le fonctionnement normal, les entrées d'alimentation des deux comparateur U1, U2 sont reliées au point commun à D1 et C2, ce point commun servant à maintenir l'alimentation des amplificateurs U1 et/ou U2 quand la tension de la batterie s'écroule suite à un court-circuit pour permettre l'activation de la disjonction.

Selon une autre particularité, la tension de référence V2 en entrée positive du comparateur U1 est fournie par une diode Zener D2, ladite diode Zener D2 étant reliée par une résistance R1 au point commun à D1 et C2, la cathode de la diode Zener D2 étant également reliée par un condensateur C1 à la borne négative de la batterie ou ensemble modulaire d'éléments.

Selon une autre particularité, le comparateur U2 à hystérésis comprend un condensateur branché en parallèle d'une résistance R4 et qui combiné avec une autre résistance R3 ou R2 forme un filtre pour filtrer des perturbations à haute fréquence et fixer un temps minimum de disjonction.

Selon une autre particularité, l'entrée positive du comparateur à hystérésis U2, est reliée par une résistance R2 au point commun à R3, R9 et R7.

Selon une autre particularité, le dispositif de détection comprend une bascule reliée à la sortie de U1 ou de U2 pour mémoriser chaque action du dispositif de détection après chaque détection de décharges profondes, de surintensité et de court-circuit.

Un autre but est de proposer un dispositif de disjonction, utilisable avec le dispositif de détection, constitué à partir de composant électroniques associés dans un montage protégeant les composants du dispositif de disjonction.

Cet autre but est atteint par, le dispositif de disjonction comportant un organe de coupure (30) dans lequel
un premier MOSFET M1 est connecté par sa source à la borne négative d'un jeu d'éléments unitaires, ledit MOSFET M1 recevant sur sa grille la source de tension qui pilote M1, ladite source délivrant une tension choisie pour que M1 soit passant,
une diode Zener D3 branchée en opposition entre la grille et la source de M1 et un condensateur C2 protègent la grille du MOSFET de tensions trop élevées ou haute fréquence et
une diode Zener D1 montée en opposition entre la grille de M1 et le drain et avec une résistance R3 et une diode D2 en sens passant dans le sens drain grille, limitent la vitesse de commutation de M1 et
un circuit constitué d'une diode Schottky D4 montée en opposition sur le drain de M1 et en série avec un condensateur C1 et une résistance R1 reliés à la borne positive de la batterie (4) pour limiter la surtension à l'ouverture de M1, en parallèle sur la diode Schottky D4 est monté une résistance fixe I1 reliée d'une part à la cathode de la diode et d'autre part au drain d'un deuxième MOSFET M2 dont la source est relié à l'anode de la diode Schottky D4, la grille de M2 étant commandée par une sortie du circuit de détection pour empêcher la charge.

Selon une autre particularité, le dispositif de disjonction comporte un second organe de coupure dans lequel
un premier MOSFET M1 connecté par sa source à la borne négative d'un jeu d'éléments unitaires, la grille de ce MOSFET M1 est commandée par une tension, cette source délivrant une tension choisie pour que M1 soit toujours passant,
un circuit constitué d'une diode Schottky D4 montée en opposition sur le drain de M1, en parallèle sur la diode D4 est monté une résistance fixe I1 reliée d'une part à la cathode de la diode Schottky D4 et d'autre part au drain d'un deuxième MOSFET M2 dont la source est reliée à l'anode de la diode Schottky D4, la grille de M2 étant connectée à la borne positive dudit jeu d' éléments unitaires,
une diode Zener D6 et une résistance R6 en série avec la grille de M2, la diode Zener D6 étant montée en sens passant dans le sens drain-grille,
une diode Zener D5 montée en opposition entre la grille et la source de M2 pour définir avec la diode Zener D6 la valeur de la tension au niveau de la grille de M2 et à laquelle M2 est passant,
un condensateur C5 monté entre la grille et la source de M2 et en parallèle de la diode Zener D5 pour protéger la grille de M2 des tensions haute fréquence,
un optocoupleur OP1 monté entre la grille et la source de M2 et en parallèle du condensateur C5 pour bloquer M2 en cas de dépassement de la tension ou de la température d'un élément du jeu d'éléments unitaires, le MOSFET M2 coupant alors le courant de charge.

D'autres particularités et avantages de la présente invention sont détaillés dans la description qui suit.

### BREVE DESCRIPTION DES FIGURES

D'autres particularités et avantages de la présente invention apparaîtront plus clairement à la lecture de la description ci-après, faite en référence aux dessins annexés, dans lesquels :
[Fig. 1]

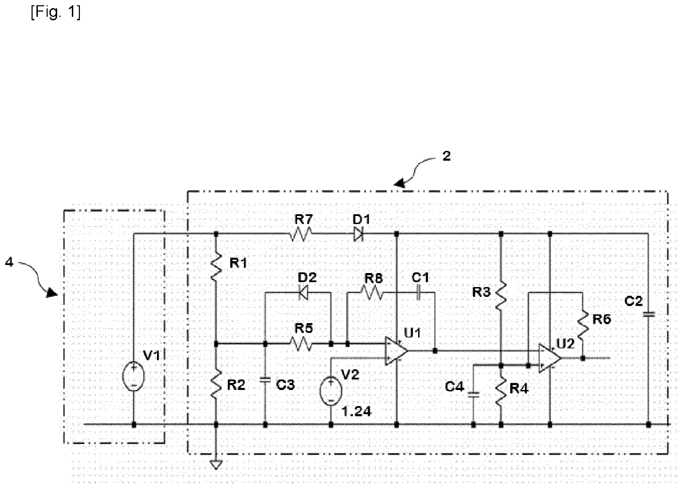

   La [fig.1] représente un schéma du circuit du dispositif détection (2) de décharges détection de décharges profondes, de surintensité et de court-circuit, selon un mode de réalisation ;
[Fig. 2]

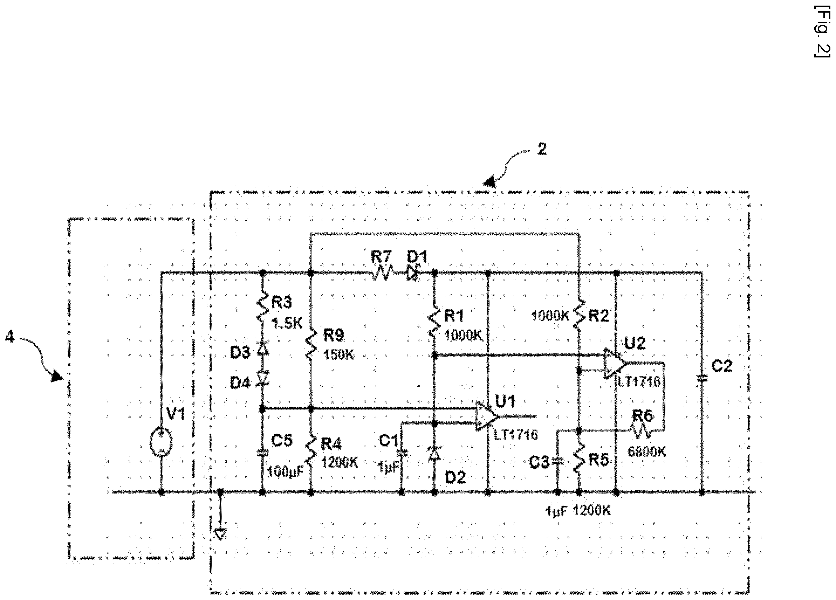

   La [fig.2] représente un schéma du circuit dudit dispositif de détection selon une variante;
[Fig. 3]

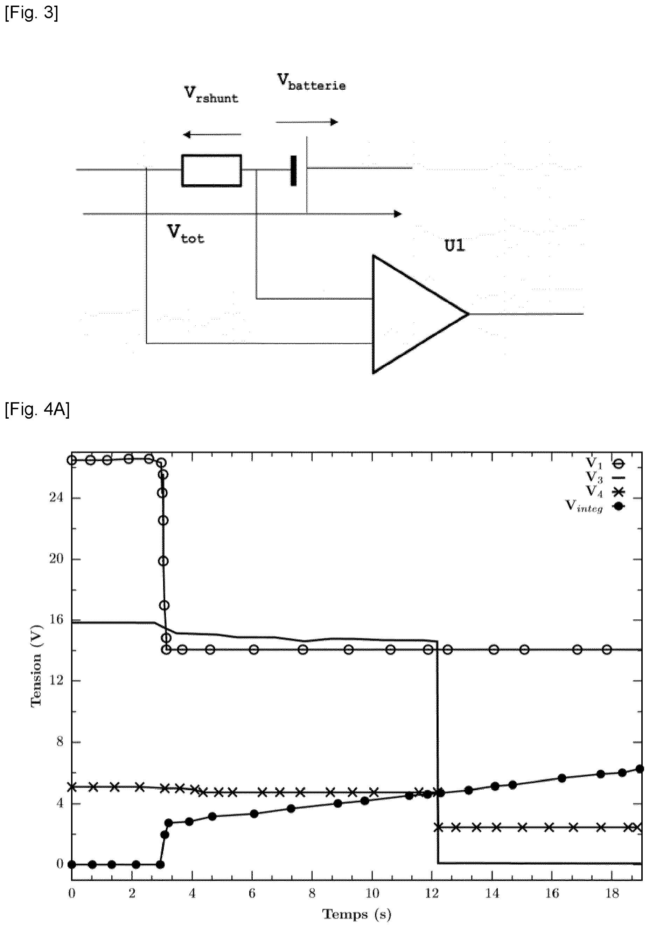

   La [fig.3] représente un schéma d'un exemple de circuit de mesure de courant par une résistance connu de l'art antérieur et présentant les inconvénients connus;
[Fig. 4A]
   La [fig.4A] représente l'affichage des évolutions de la tension aux bornes des comparateurs U1 et U2 en cas de surintensité selon un mode de réalisation pour une batterie de 24,4 Volts et tension de détection ou déclenchement Td de 16 Volts ;
[Fig. 4B]

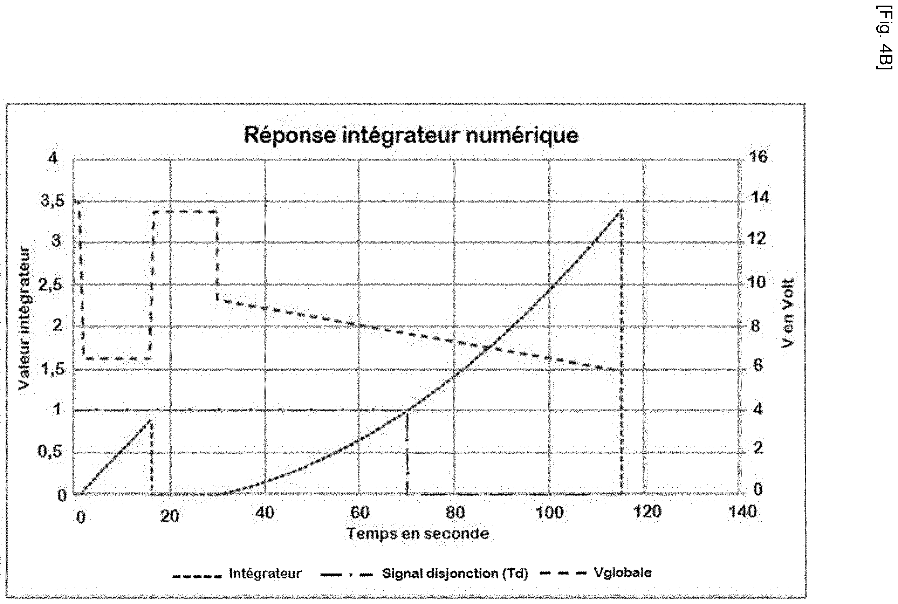

   La [fig.4B] représente la réponse d'un montage intégrateur numérique fonctionnant selon le logigramme de la [fig.]4D selon un mode de réalisation utilisé avec une batterie de 16 Volts et une tension de détection ou déclenchement Td de 12Volts;
[Fig. 4C]

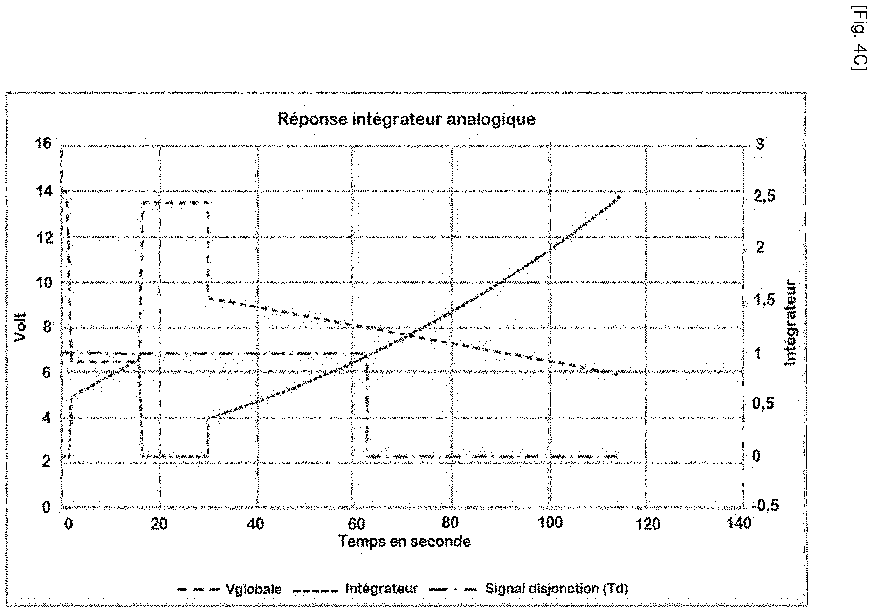

   La [fig. 4C] représente la réponse d'un montage intégrateur analogique selon un autre mode de réalisation analogique utilisé avec une batterie de 16 Volts et une tension de détection ou déclenchement Td de 12 Volts ;
[Fig. 4D]

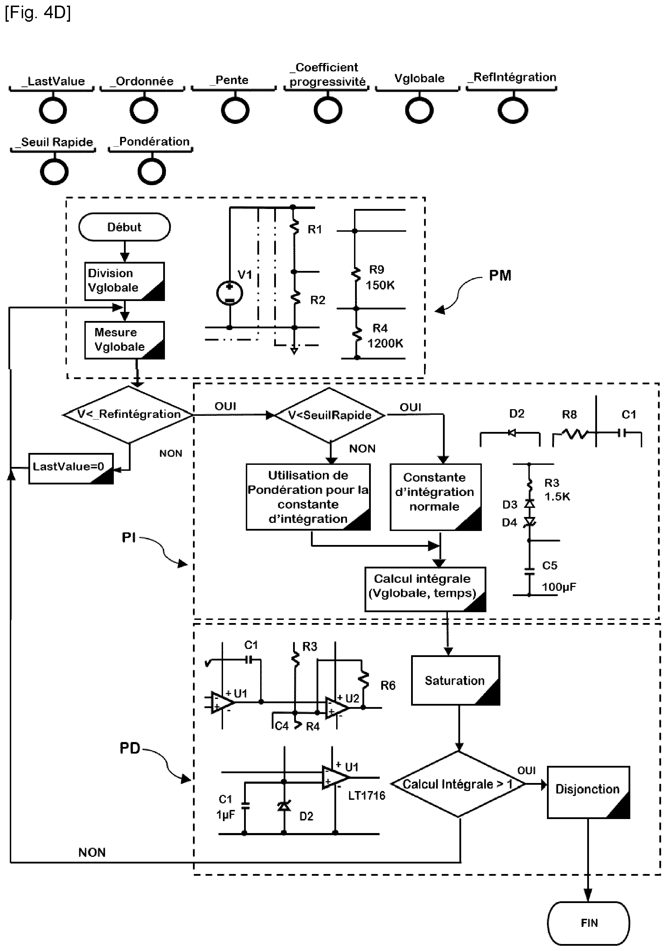

   La [fig. 4D] un logigramme explicitant le programme de calcul de la réponse d'un montage intégrateur numérique selon un mode de réalisation avec mise en parallèle des modes de réalisation analogiques;
[Fig. 4E]

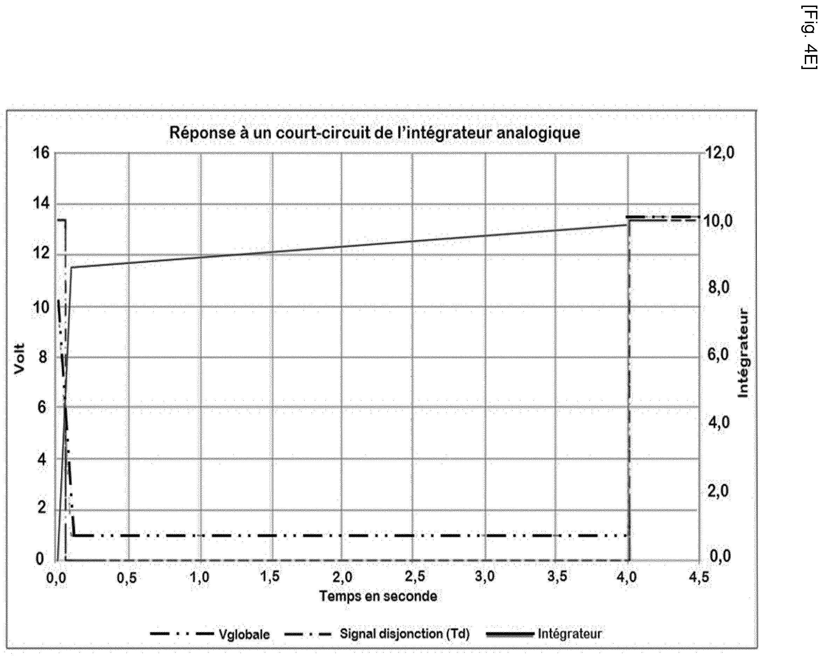

   La [fig. 4E] représente la réponse, en cas de court-circuit, d'un montage intégrateur analogique selon un mode de réalisation analogique utilisé avec une batterie d'environ 14 Volts et une tension de détection ou déclenchement Td de 14 Volts en cas de court-circuit ;
[Fig. 4F]

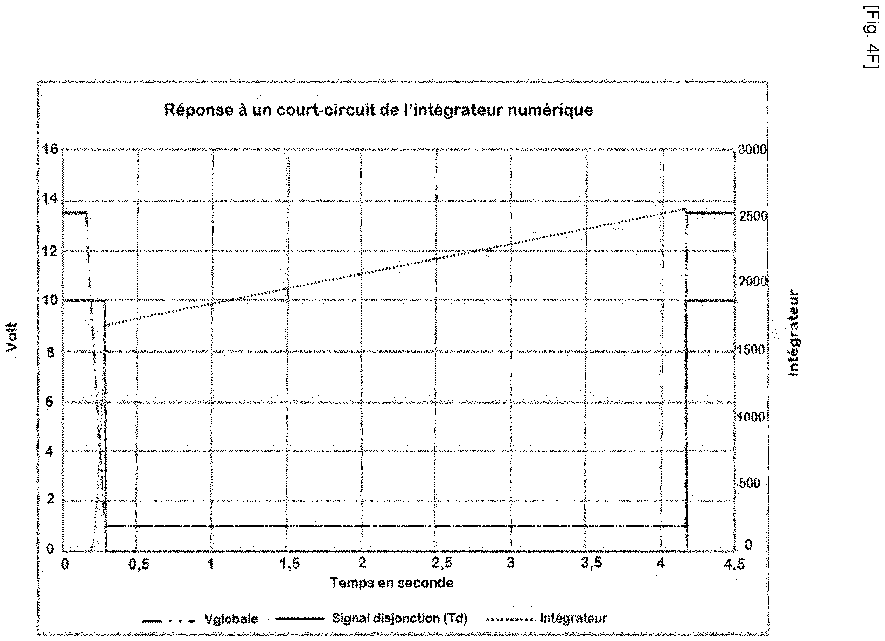

   La [fig. 4F] représente la réponse, en cas de court-circuit, d'un montage intégrateur numérique fonctionnant selon le logigramme de la [fig.]4D selon un mode de réalisation utilisé avec une batterie d'environ 14 Volts et une tension de détection ou déclenchement Td de 10Volts ;
[Fig. 4G]

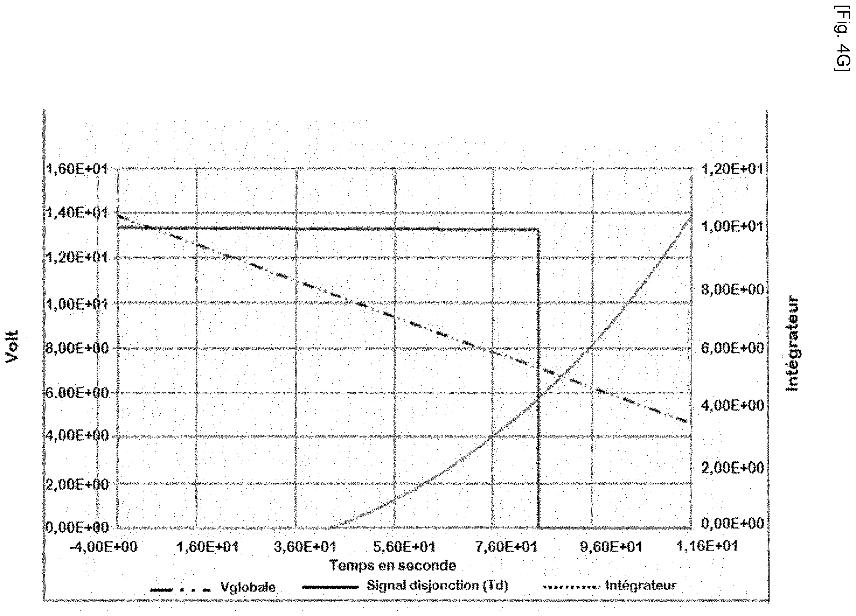

   La [fig. 4G] représente la réponse, en cas de décharge lente, d'un montage intégrateur analogique selon un mode de réalisation analogique utilisé avec une batterie d'environ 14 Volts et une tension de détection ou déclenchement Td de 14 Volts ;
[Fig. 4H]

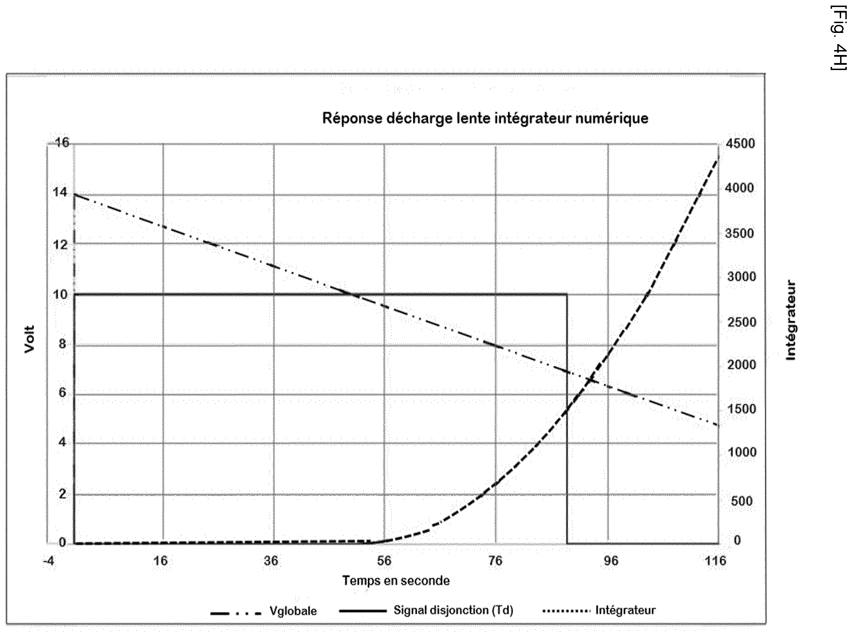

   La [fig. 4H] représente la réponse, en cas de décharge lente, d'un montage intégrateur numérique fonctionnant selon le logigramme de la [fig.]4D selon un mode de réalisation utilisé avec une batterie d'environ 14 Volts et une tension de détection ou déclenchement Td de 10Volts ;
[Fig. 4I]

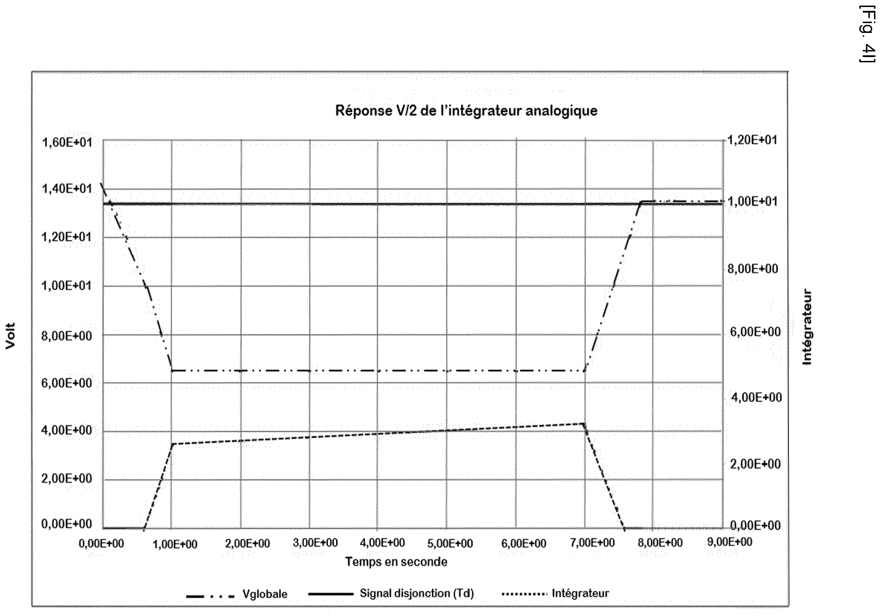

   La [fig. 4I] représente la réponse, en cas de décharge à V/2, d'un montage intégrateur analogique selon un mode de réalisation analogique utilisé avec une batterie d'environ 14 Volts et une tension de détection ou déclenchement Td de 14 Volts pour déterminer le courant maximal de la batterie;
[Fig. 4J]

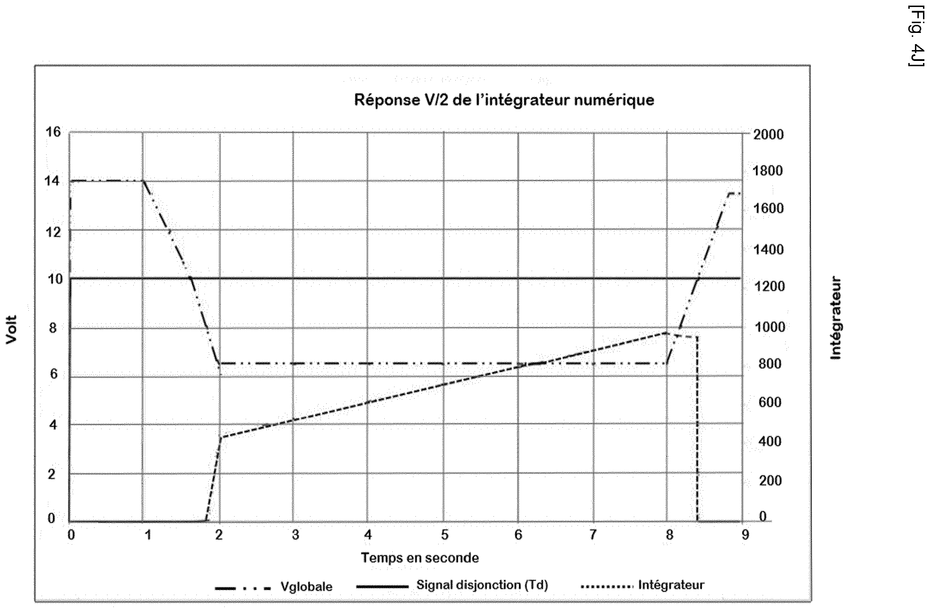

   La [fig. 4J] représente la réponse, en cas de décharge à V/2, d'un montage intégrateur numérique fonctionnant selon le logigramme de la [fig.]4D selon un mode de réalisation utilisé avec une batterie d'environ 14 Volts et une tension de détection ou déclenchement Td de 10Volts pour déterminer le courant maximal de la batterie;
[Fig. 5]

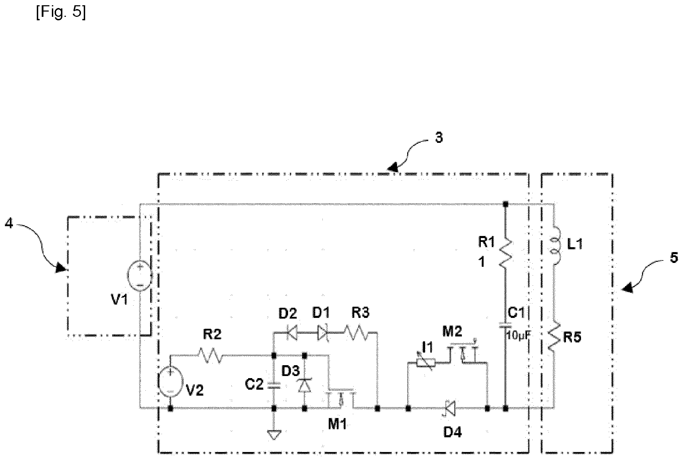

   La [fig. 5] représente un schéma du circuit du premier organe de coupure à la décharge du dispositif de disjonction, selon un mode de réalisation ;
[Fig. 6]

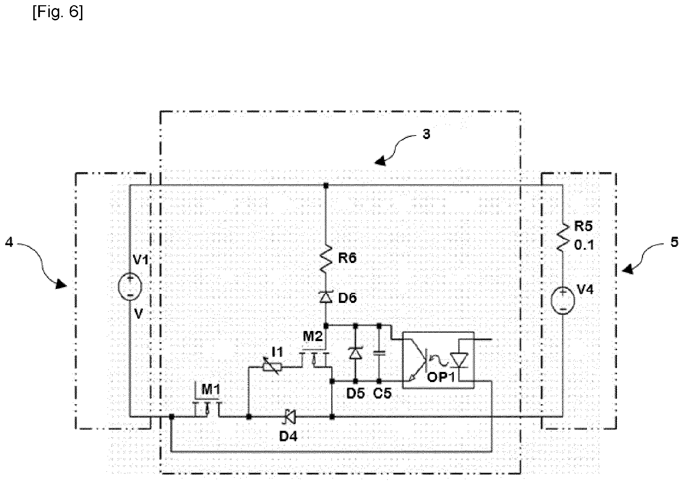

   La [fig. 6] représente un schéma du circuit du second organe de coupure à la charge du dispositif de disjonction, selon un mode de réalisation ;
[Fig. 7]

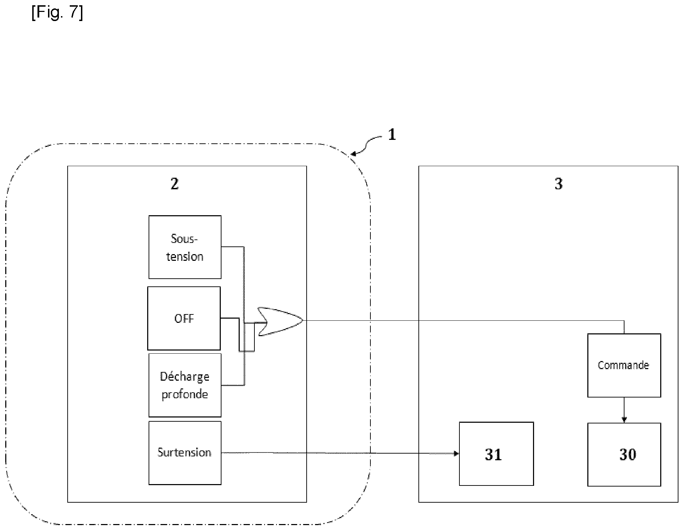

   La [fig. 7] représente un schéma de l'interconnexion entre le système de gestion de batterie (BMS) et le dispositif de disjonction, selon un mode de réalisation ;
[Fig. 8]

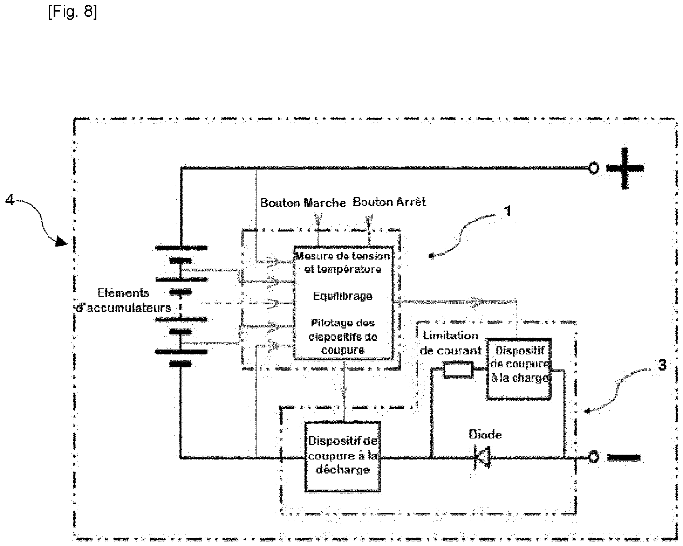

   La [fig. 8] représente le schéma d'une batterie comportant un BMS et un dispositif de disjonction, selon un mode de réalisation,
[Fig. 9]

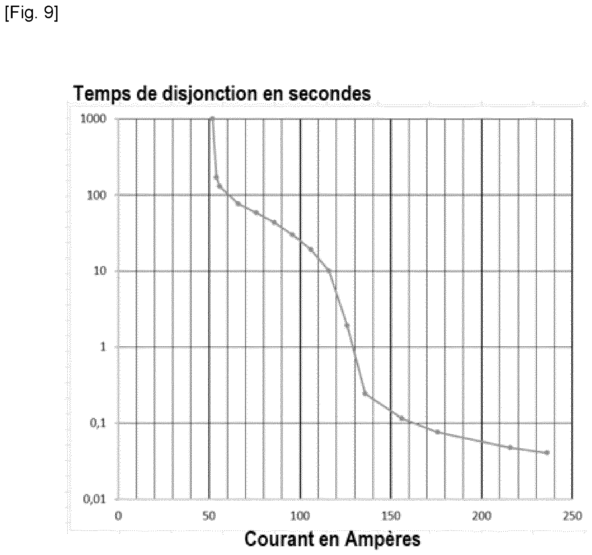

   La [fig. 9] représente le schéma d'une caractéristique de disjonction, obtenu par le dispositif de détection tel que décrit et très proche de celle d'un disjoncteur magnétothermique de l'état de l'art, selon un mode de réalisation.

### DESCRIPTION DES MODES DE REALISATION

La présente invention concerne un procédé et un système (1) de gestion de batteries (BMS) d'accumulateurs.

Lesdites batteries peuvent être constituées d'un élément unitaire ou de plusieurs éléments unitaires ou cellules pouvant être arrangés en ensemble modulaire connectés en série, en parallèle ou en pluralité d'ensemble modulaire série associés en parallèle pour constituer une batterie (4), et un dispositif de disjonction (3) électronique relié d'une part à au moins un pôle d'une cellule et d'autre part à une borne de même polarité d'un ensemble modulaire ou d'une batterie (4).

Selon une autre variante, le système (1) de gestion de batteries (BMS) d'accumulateurs, comprend au moins un dispositif de détection (2) de décharges profondes (ou lentes), de surintensité et de court-circuit dans chaque élément unitaire ou ensemble modulaire de la batterie (4) et qui comprend au moins un dispositif BMS (la [fig.8] illustre une batterie avec un dispositif BMS), ledit système (BMS) étant caractérisé en ce que le dispositif de détection (2) est unique.

Le dispositif de détection (2) comprend un comparateur U1 analogique ou (Un) numérique qui compare directement une tension proportionnelle, dans un rapport déterminé, à celle de l'élément unitaire ou de l'ensemble modulaire, sans utiliser un shunt résistif, à une tension de référence (V₂ ou Refintégration) et évalue les variations de la tension pour activer ou non la disjonction de chaque élément unitaire ou ensemble modulaire de la batterie (4) en fonction d'une tension de détection Td à partir de laquelle le dispositif de disjonction est actionné.

Le rapport de proportion entre la tension mesurée et celle de référence correspond au rapport entre la tension de référence (V₂ ou Refintégration) et la tension de détection ou déclenchement Td à partir de laquelle le dispositif de disjonction est actionné.

La [fig.3], illustre un exemple de mesure de courant par résistance shunt. Cette mesure implique de mettre un shunt en série sur la ligne. La tension globale Vₜₒₜ, est donnée par Vₜₒₜ=V_{batterie} - Vᵣₛₕᵤₙₜ avec Vᵣₛₕᵤₙₜ=R*I la valeur aux bornes de la résistance shunt. Donc plus I est important plus la chute de tension est importante. Dans ce cas, la consommation d'un comparateur U1 est très importante, 1 mA pour un amplificateur différentielle contre moins 10µA pour la mesure de tension.

Par ailleurs, la tension V_{batterie} mesurée aux bornes de la batterie ou de chaque élément est de la forme V_{batterie} = E-R*I, avec E la tension à vide, R résistance interne et I le courant débité par la batterie. E et R sont connus pour une batterie donnée et la tension V_{batterie} permet d'avoir accès à I le courant débité. La puissance maximale qu'une batterie est capable de fournir est proche de la valeur (E/2) *(I_{cc}/2) (avec E la tension à vide et I_{cc} le courant de court-circuit). Comme la résistance interne tend à augmenter avec le vieillissement de la batterie, alors la puissance maximale diminue avec le vieillissement de la batterie. Le fait de disjoncter en surveillant la tension V_{batterie} plutôt que le courant permet de protéger de façon optimale une batterie tout au long de sa vie. Il est alors évident que la détection par mesure de la tension est avantageuse.

En outre, en cas de panne d'une ligne ou deux comprenant un ensemble d'éléments unitaires ou cellules de la batterie, le dispositif de détection du système (1) de gestion de batteries (BMS), tel que décrit selon l'invention, est configuré (notamment via une détection par mesure de tension) pour auto-adapter le seuil ou tension de déclenchement Td pour la détection de conditions anormales (décharge profonde, court-circuit, surintensité) de la batterie. En d'autres termes, le dispositif de détection du système (1) de gestion de batteries permet de protéger la batterie quel que soit son état de vieillissement.

Les éléments unitaires d'accumulateurs d'une batterie (4) à protéger peuvent par exemple, et de manière non limitative, les caractéristiques suivantes :
Tension à vide = 3,3 V
Résistance interne = 0,012 Ohm (avec les connexions)
Courant maximum= 70 A ; 120 A 10 s
Tension de fin de décharge = 2 V
Tension en fin de charge = 3,6 V
Tension maxi = 4 V

Une batterie (4) peut être modélisée par une source de tension parfaite en série avec une résistance interne. Dans le cas, donné à titre d'exemple, d'un assemblage « 8S1P » de 8 éléments unitaires en série, par exemple et de manière non limitative, nous avons une tension à vide (ou de fin de charge) de 26,4 V et une résistance interne de 0,1 Ohm (avec les connexions). Ainsi, le courant de court-circuit peut atteindre 264 A, alors que le courant maximum spécifié vaut 120 A pendant 10 s. Une protection contre les surintensités est donc nécessaire.

Le schéma du circuit de détection de défauts (ou de conditions anormales) revendiqué, illustré par la [fig.1], comprend un diviseur de tension R1 et R2, une référence de tension V2 de 1,24 V par exemple, et de manière non-limitative, et V1 est la tension aux bornes de la batterie que le dispositif surveille. Dans l'exemple ci-dessus, la tension en fin de décharge ne doit pas descendre en dessous de 2 V par élément, soit 16 V pour 8 éléments en série. On peut alors choisir comme valeur de la tension de détection ou déclenchement Td, V1=16V. Pour cette valeur de la tension de détection ou déclenchement, le rapport de division du diviseur de tension R1 et R2 sera choisi égal à V2/Td ; c'est à dire 1,24 V/16 V = 0,0775. Ainsi, en fonctionnement statique, quand la tension de la batterie (4) est supérieure à la tension de détection ou déclenchement Td =16 V, la tension appliquée à l'entrée - de l'amplificateur U1 est supérieure à 1,24 V, sa sortie est à l'état «non conducteur», la sortie du comparateur U2 est à « l'état conducteur» et le fonctionnement est « normal » pas de disjonction.

Quand la batterie (4) se décharge lentement (décharge profonde) et que sa tension descend en dessous de 16 V, la tension appliquée à l'entrée - de l'amplificateur U1 est inférieure à 1,24 V, sa sortie passe à l'état « conducteur », la sortie du comparateur U2 passe à « non conducteur» et la disjonction est activée. La sortie du comparateur (ou amplificateur) U1 est l'intégrale de la tension à surveiller selon un mode de réalisation analogique [fig. 4C] ou un autre mode de réalisation numérique [fig. 4B]. Ainsi comme représenté sur ces figures si la tension V_{globale} évolue de façon linéaire, la sortie de l'intégrateur sera une fonction du deuxième degré. Si la variation de la tension est une droite de forme ax+b, alors la sortie est une fonction de type ax² + bx + c.

Dans l'expression de la tension aux bornes d'une batterie ou d'un élément unitaire de la batterie donnée par V_{batterie}= E-R*I, c'est E, la tension à vide qui diminue quand la batterie est complètement déchargée.

Quand la batterie (4) fournit un fort courant (surintensité), par exemple 120 A, sa tension chute rapidement à 14,4 V (courbe V1 [fig. 4A]) Le montage ci-dessus détecte cette situation.

En cas de court-circuit, la tension V1 chute très rapidement à une valeur très faible, et la tension aux bornes de R2 est proche de 0 V et cette situation est également détectée.

Ce même montage pourra être utilisé dans une autre variante de réalisation de la [fig. 2] (montage avec diode Zener D4) en remplaçant les résistances R1, R2 par des résistances R9, R4.

Le dispositif de détection, tel que décrit dans la présente demande, permet la détection de variation de tension avec une progressivité non linéaire de sorte qu'une forte surintensité provoque une disjonction de la batterie au bout d'une période comprise entre 10ms et 100ms et qu'une faible surintensité provoque une disjonction dans un temps compris entre 10s et 100s.

L'effet d'une surintensité ou d'un court-circuit est de provoquer un échauffement des composants de la batterie pouvant conduire à un incendie. La dissipation de chaleur est proportionnelle au carré de l'intensité, ainsi la disjonction doit être d'autant plus rapide que le dépassement de courant est important. Un fusible ou un disjoncteur magnéto-thermique coupe le courant en un temps d'autant plus court que le dépassement de courant est important. Cela implique la fixation d'un courant maximal et une faible protection de la batterie en cas de vieillissement des composants de la batterie, ceux-ci ne pouvant pas supporter une certaine valeur maximale du courant due à l'augmentation de la résistance interne de la batterie avec le vieillissement. Autrement dit, en cas de vieillissement le courant maximal fixé ne pourra pas être atteint et la détection et la protection de la batterie ne seront pas efficaces. Au contraire, dans la présente invention qui concerne, en particulier, un dispositif de détection de surintensité basé sur une mesure de l'évolution de la tension aux bornes de la batterie en fonction du temps, il n'y a pas de contrainte liée à la fixation d'une valeur maximale du courant. Si la tension mesurée est inférieure à une certaine valeur correspondant à une faible intensité du courant, alors le temps de disjonction sera long, comme illustré sur la [fig. 9]. Si la tension mesurée est inférieure à une certaine valeur correspondant à une forte intensité ou un court-circuit, alors le temps de disjonction sera court (voir [fig. 9]). Cela permet une sécurisation de la batterie quel que soit le vieillissement de ses composants.

La fonctionnalité de détection par mesure de la tension de la batterie combinée à l'utilisation d'un disjoncteur électronique permet, en particulier, d'émuler le comportement d'un disjoncteur magnéto-thermique sans la contrainte de fixation d'un courant maximal pour améliorer la sécurisation de la batterie. Par exemple, la [fig. 9] qui illustre une courbe de disjonction obtenue via un disjoncteur électronique selon l'invention, est semblable à celle d'une courbe de disjonction obtenue via une mesure shunt et un disjoncteur magnéto-thermique, mais avec une bien meilleure précision.

Les modes de réalisation apportent des compléments de protection au fonctionnement du circuit pour préserver la durée de vie des composants ou pour éviter d'avoir à choisir des composants onéreux car répondant à un cahier des charges élevé. Ces modes de réalisation peuvent ne pas être combinés en totalité entre eux ou avec la réalisation principale.

Ainsi le dispositif de détection (2) comprend un diviseur de tension formé par au moins deux résistances R1 et R2, le diviseur de tension étant connecté aux bornes de la batterie pour abaisser la tension à l'entrée du comparateur U1.

De même une résistance R5 est branchée entre le point commun du pont diviseur R1, R2 et l'entrée négative du comparateur U1 et un ensemble résistance R8, condensateur C1 monté en série par une borne commune est branché par l'autre borne de C1 à la sortie du comparateur U1 et l'autre borne de R8 est reliée au point commun aux deux résistances R5, R8 et à l'entrée négative de U1.

Dans une autre mode de réalisation, une diode D2 est branchée en parallèle sur la résistance R5, avec sa cathode reliée au point commun du pont diviseur. La diode D2 permet, dans cette configuration, de changer la constante de temps d'intégration du montage intégrateur dans le cas d'un appel de courant très important ou élevé par exemple dans le cas d'une surintensité ou un court-circuit. Ce changement de la constante de temps d'intégration est équivalent à l'utilisation d'une pondération dans l'intégration du signal (tension) dans le cas d'un intégrateur numérique (voir ci-après).

Ainsi en cas de surintensité, illustré par la [fig.4A], la batterie (4) fournit un fort courant, par exemple 120 A, sa tension chute rapidement à 14,4 V (V₁, [fig.4A]). La différence de tension entre 26,4 V et 14,4 V est intégrée par le circuit intégrateur R5-R8-C1 (au sens intégrale mathématique) branché aux bornes de l'amplificateur U1, avec une constante d'intégration qui dépend principalement de R5 - C1. Sa sortie (V_{integ}, [fig. 4A]) évolue lentement de « 0 V » vers « Vcc tension de court-circuit» et le comparateur à hystérésis U2 bascule (V₃, [fig. 4A]) quand son seuil (V₄, [fig. 4A]) tension de détection ou déclenchement Td est atteint. La disjonction est activée. La constante de temps R5 - C1 est réglée pour que la disjonction intervienne avant 10 s à 12 s dans ce cas.

Lors de court-circuit, la tension V1 chute très rapidement à une valeur très faible, et la tension aux bornes de R2 est proche de 0 V. La diode D2 conduit, la tension à l'entrée - de U1 vaut 0,6 V (l'entrée + est toujours à 1,24 V) et la sortie de U1 passe rapidement à « Vcc ». La sortie du comparateur U2 passe à « 0 » et la disjonction est activée.

Dans tous ces cas, une bascule mémorise cette action, et il est nécessaire de « resetter » (c'est-à-dire réinitialiser) la batterie (4) par une action sur un bouton « marche » accessible de l'extérieur du boitier de batterie.

Les condensateurs C3 et/ou C4 filtrent d'éventuelles perturbations à haute fréquence, et fixent le temps minimum de disjonction.

Le principe de mesure via un montage intégrateur tel que décrit dans la présente demande est un principe de mesure d'une tension globale qui permet de remonter à une valeur de courant. Ce principe n'est valable dans le domaine de la batterie que lorsque l'on connait la résistance interne du générateur de tension. Dans ce cas et uniquement dans ce cas, on peut utiliser ledit montage intégrateur soit en analogique (tel que représenté sur la [fig.1]) soit en numérique.

Par exemple, et de manière non limitative, la réponse ou la sortie d'un intégrateur numérique peut être calculée de la manière suivante :

Soit une variation de la tension représentée par x= (-0.25*V_{globale} + 2.5)*pondération, où V_{globale} est une tension obtenue à partir de la tension de la batterie par l'utilisation d'un pont diviseur de tension (R1-R2 ou R9-R4) et pondération est une variable qui permet de changer la constante d'intégration. L'équation ci-dessus est modifiable suivant les accumulateurs utilisés.

La sortie ou réponse de l'intégrateur numérique ayant pour forme générale y = Intégration(x), où Intrégration( ) représente le calcul intégral, peut être calculée en utilisant soit comme une première équation de progressivité consistant à prendre la valeur de x, ci-dessus définie, et de l'élever à une puissance paire (2, 4, 6, 8...), par exemple y = x².

Pour se rapprocher encore plus de l'intégrateur analogique (figures [fig.4A], [fig.4C]), une seconde équation de progressivité définie, par exemple et de manière non-limitative, par y= Taux *(-In(x)), avec Taux, une constante d'intégration exprimée en seconde, peut être utilisée. Cette équation permet d'imiter le comportement d'un condensateur dont la tension à ses bornes évolue comme une exponentielle.

La [fig. 4D] représente un diagramme de calcul de la réponse d'un intégrateur numérique selon la seconde équation de progressivité. Chaque étape de calcul représente les composants du dispositif de détection pouvant être impliqués dans les opérations de calcul. Le diagramme peut être divisé en trois phases: phase de mesure (PM) et comparaison, phase d'intégration (PI) et phase de disjonction (PD).

Dans la phase de mesure (PM), le pont diviseur de tension R1-R2 (ou R9-R4) permet de déterminer une mesure V=V_{globale} de la tension à l'entrée du dispositif de détection à partir de la tension V1 de la batterie.

La variable «Refintégration » est la référence d'intégration et correspond à une valeur de la tension en dessous de laquelle, le signal d'entrée V sera intégré. Si la tension V est supérieure à la variable « Refintégration », on se trouve dans une situation ou la batterie fonctionne normalement. Si V est inférieure à la variable « Refintégration », la batterie fonctionne anormalement et le processus pouvant conduire à la disjonction de ladite batterie est déclenché. Cette variable « Refintégration » est donc équivalente à la tension de référence V₂. On entre alors dans la phase d'intégration où la réponse de l'intégrateur doit être calculée.

Dans le cas où la tension V est inférieure à la variable « Refintégration » le programme déclenche soit l'utilisation d'une constante normale d'intégration dans le calcul effectué, soit l'utilisation d'une pondération pour la constante d'intégration. Cette pondération comme représenté dans le cadre PI est utilisée si la tension est inférieure à une deuxième variable de comparaison appelée « SeuilRapide » qui permet de définir un seuil de tension à partir duquel la variable « pondération » (ci-dessus définie) est utilisée dans le calcul de la variation de la tension ou non. Par exemple, et de manière non-limitative, la variation de la tension a une forme générale de type x = (pente * V_{globale}+ ordonnée)*pondération.

Si la différence ou variation de la tension d'entrée V, dV, entre un instant t1 et un instant t2 (ou entre deux mesures successives de la tension V), définie par dV = |V(t2)-V(t1)|, est supérieure à la variable « SeuilRapide », la variable « pondération » prend par exemple la valeur 5. Si, au contraire, ladite différence ou variation de la tension d'entrée V, dV, est inférieure à la variable « SeuilRapide », la variable « pondération » prend la valeur 1. Ce qui correspond à utiliser une constante d'intégration normale.

Le pas de temps de mesure de la tension peut être compris, par exemple et de manière non-limitative, entre 1ms à 100 ms. La valeur de la variable « SeuilRapide » peut être définie en fonction du pas de temps de mesure et en surveillant la variation de tension entre deux instants t1 et t2, correspondant au dit pas de temps, utilisé pour effectuer les mesures de tension, afin d'améliorer les conditions de détection de conditions anormales. Par exemple, et de manière non-limitative, pour la [fig. 4B], le pas de temps de mesure utilisé est de 10ms et la valeur de « SeuilRapide » est 0.01 Volt. Ce qui correspond à une chute de tension dV= 0.01 Volt toutes les 10ms.

Les variables « Ordonnée », « Pente», obtenues par mémorisation des points de mesure et calcul, par exemple par un fit des données mémorisées de la tension ou par l'utilisation de deux points de la courbe de tension mémorisée entre deux instants t1 et t2 pour déduire la « pente » (pour une variation linéaire de la tension) puis l' « ordonnée », permettent de définir la variation de tension. Dans l'exemple où x= (-0.25*V_{globale} + 2.5)*pondération, la pente est -0.25 et l'ordonnée 2.5.

L'étape de comparaison de la variation de tension dV, équivaut à une étape de comparaison de la pente calculée avec la valeur « Seuilrapide » mémorisée soit, pour appliquer, en cas de dépassement par la pente de la valeur « Seuilrapide », un coefficient de pondération (par exemple 5) augmentant l'accélération de l'évolution de l'intégrale pour qu'elle franchisse plus vite le seuil Td de tension de déclenchement, soit en cas de non dépassement un coefficient de pondération sans effet d'accélération (par exemple 1).

Une fois que la variation de la tension est obtenue, le signal est intégré selon la seconde équation de progressivité par exemple. Le signal de sortie correspond ainsi à l'intégration du signal d'entrée.

La variable « Coeff progressivité » correspond à une constante d'intégration (Taux dans la seconde équation de progressivité).

Dans le mode de réalisation, par intégrateur numérique, l'homme de métier comprendra que le montage utilisant les comparateurs U1 et U2 est remplacé par un microprocesseur jouant le rôle d'un comparateur numérique (Un). Ledit microprocesseur est équipé d'une mémoire de stockage permettant la mémorisation des variables de seuil « Refintégration » et « SeuilRapide » et les variables de calcul « Ordonnée », « Pente» définies en fonction de ces seuils. La mémoire contient également le programme de calcul permettant la collecte des points de courbe de tension (V_{globale}, ...), les comparaisons et décisions, la mise en oeuvre des équations, l'intégration et les décisions représentées dans le logigramme de la [fig. 4D]. Le circuit numérique reçoit seulement en entrée la tension V_{globale} provenant du point commun d'un pont diviseur entre une résistance R1 et une résistance R2 et effectue des mesures selon une fréquence déterminée pour observer la courbe de tension V_{globale}, puis à partir de la détection du franchissement du seuil « Refintégration » qui, sur l'exemple de la [fig. 4B] est choisi inférieur 3 Volts par élément cellulaire ou 12 volts pour une batterie de 4 éléments cellulaires en série à partir de cette Tension de référence V₂ le programme du microprocesseur, déclenche les calculs pour obtenir la comparaison avec la variable « Seuilrapide » de la variation dV de la tension V_{globale} entre deux instants successifs t1 et t2 (ou entre deux mesures successives), afin de déterminer l'utilisation ou non d'une variable « Pondération ». Ainsi, dans le cas d'un démarrage entraînant une chute importante de la tension de 14 à presque 6 Volts, la variable « Seuilrapide » est par exemple, et de manière non-limitative, fixée à 0.01 volt dans l'exemple de la [fig. 4B]. La variable « Seuilrapide » sera franchie et l'intégration se fera avec une pondération pour éviter une coupure trop rapide empêchant le démarrage. Sur le diagramme de la [fig. 4B] on peut observer que la tension batterie ayant chuté rapidement à presque 6 Volts et restant constante pendant environ 18 secondes, le circuit numérique intègre la valeur constante en une droite qui reste en dessous de la tension de détection ou déclenchement Td qui est choisie à 1 Volt. La réponse de l'intégrateur ou tension de sortie peut être, par exemple et de manière non-limitative, obtenue avec un programme tel que celui définie en annexe de la présente demande où la variable «tensionGenerale» correspond à la tension V_{globale} à un instant t1 = t et, la variable «LastTensionGenerale» représente la valeur de la tension V_{globale} à l'instant t2=t-1. La variable «ORDONNEE_ORIGINE» correspond à la variable «Ordonnée» définie ci-dessus et la variable «lastlntegratedValue» correspond au calcul intégral ou la réponse de l'intégrateur.

Le calcul de l'intégrale ou de la réponse de l'intégrateur peut comprendre la prise en compte des variables « Pente et/ou Ordonnée » calculées par le microprocesseur à partir des données de la courbe de tension V_{globale} enregistrée.

L'intégration se déclenche dès que la tension globale V_{globale} passe en dessous de V₂= Refintégration= 9 Volts.

Ensuite au cours de son utilisation la tension de la batterie chute brutalement de 14 Volts à environ 9 Volts puis décroit lentement dans le temps selon une droite jusqu'à 6 volts. L'ordonnée de la droite est environ 2,3 volts et la pente est moins élevée que précédemment et la variation dV de la tension entre deux mesures successives peut être supérieure (en fonction de la valeur de la pente) à la variable « Seuilrapide » (par exemple 0.01 volt dans l'exemple représenté [fig. 4B]).

Lorsque la valeur en sortie de l'intégration atteint le seuil correspondant à la tension de détection ou déclenchement Td de 1 volt, le déclenchement de la coupure est réalisé.

Enfin dans la version ou variante numérique, lors de court-circuit, la tension V_{globale} chute très rapidement à une valeur très faible un seuil de détection de court circuit est mémorisé et dès que le processeur détecte le franchissement de ce seuil il active le signal de déclenchement de disjonction.

Dans la [fig. 4B] illustrant la réponse ou signal de sortie d'un intégrateur numérique selon l'exemple décrit ci-dessus, l'intégrateur numérique présente un comportement qui se rapproche de celui d'un intégrateur analogique ([fig.4C]) dans l'intervalle de temps compris entre t=40s et environ t=120 s.

Dans la phase de disjonction, le calcul de la réponse est utilisé pour vérifier si une disjonction doit être déclenchée (ou activée) ou pas. La disjonction est activée lorsque la réponse de l'intégrateur est supérieure à un seuil donné correspondant à la tension de détection ou déclenchement Td. Dans l'exemple ci-dessus, illustré par les figures [fig.4B], [fig.4C] et [fig.4D], ce seuil est fixé à 1 ou 1,24 Volts environ. Par exemple et de manière non limitative, la valeur du seuil peut être normalisée à 1.

Les figures [fig.4E] et [fig.4F] illustrent respectivement la réponse d'un intégrateur analogique et d'un intégrateur numérique dans le cas de détection d'un court-circuit. Le pas de temps de mesure est fixé à 10ms et la valeur de la variable « Seuilrapide » est égale à 0.1V.

Sur l'exemple de la [fig. 4F] montrant la réponse d'un intégrateur numérique, on peut observer une chute de la tension V_{globale} aux bornes de la batterie d'une valeur d'environ 14 V à une valeur proche de 0 V dans un intervalle de temps compris entre 0.2 s et 0.3s et, dans lequel, le circuit intégrateur numérique intègre le signal d'entrée avec une valeur de pondération = 150 pour augmenter l'accélération de l'évolution de l'intégrale. Cette pondération est effectuée pour que le signal de sortie ou la réponse franchisse le plus vite le seuil de déclenchement Td = 10 V (qui est fixé à 14V dans le cas de l'intégrateur analogique). Cette valeur de Td peut être normalisée à 1, comme mentionné ci-dessus. De 0.3 s à environ 4.2 s, la valeur de V_{globale} reste constante et proche de 0 V et, la réponse du circuit intégrateur numérique est une droite qui passe au-dessus de la tension de déclenchement Td de la disjonction après une durée d'environ 1s. Lorsque la batterie retrouve son fonctionnement normal, après une 4.2 s, la réponse du circuit intégrateur numérique est nulle. Le comportement de l'intégrateur numérique est similaire à celui du circuit intégrateur analogique illustré par la [fig. 4E].

Les figures [fig.4G] et [fig.4H] illustrent respectivement la réponse d'un intégrateur analogique et d'un intégrateur numérique dans le cas de la détection d'une décharge lente ou profonde. Le pas de temps de mesure est également fixé à 10ms et la valeur de la variable « Seuilrapide » est égale à 0.1V.

Comme illustré sur la [fig. 4H], pendant la décharge lente ou profonde, le signal ou la tension d'entrée V_{globale} évolue comme une droite décroissante de 14 V à environ 5V dans un intervalle de temps compris entre 0 et 116 s. Le circuit intégrateur numérique (ou intégrateur numérique) intègre le signal d'entrée en prenant en compte une valeur de pondération égale à 150. Le processus de disjonction est déclenché lorsque la courbe de réponse est supérieure à la valeur de la tension de déclenchement Td fixée dans cet exemple à environ 10V (qui est fixée à environ 14 V dans le cas de l'intégrateur analogique). Tout comme dans les cas de détection de conditions anormales telles que la surintensité ([fig. 4B]), le court-circuit ([fig. 4F]), le comportement de l'intégrateur numérique est également similaire à celui du circuit intégrateur analogique illustré par la [fig. 4G] en cas de décharge lente.

Ainsi, l'homme de métier comprendra que le système de gestion de batteries tel que décrit dans la présente demande est adapté pour la détection de conditions anormales comportant au moins la surintensité, le court-circuit et la décharge lente ou profonde. Cette détection est effectuée sans avoir à changer un composant électronique du dispositif de détection, qui est unique, ou à intégrer un nouveau composant électronique selon la ou les conditions anormales que l'on souhaite détecter. Un autre avantage est qu'il n'est pas nécessaire que le dispositif de détection comprenne autant de circuits électroniques que de conditions anormales à détecter. Cela permet d'éviter une surcharge du système de gestion qui peut entraîner des problèmes de maintenance en cas de panne (en particulier dans la recherche de la source de la panne).

Les figures [fig. 4I] et [fig. 4J] illustrent respectivement la réponse d'un intégrateur analogique et d'un intégrateur numérique à une décharge V/2. La décharge à V/2, qui s'effectue sur une courte période, par exemple environ 15s, permet de déterminer le courant maximal supporté par la batterie.

Dans certains modes de réalisation, le système (1) de gestion de batteries (BMS) d'accumulateurs comprend au moins autour d'un comparateur U1 un pont diviseur (R1, R2, ou R9, R4) monté entre les bornes de l'ensemble modulaire de la batterie (4) ou d'une cellule unitaire de la batterie (4) dont le point commun aux résistances est relié à l'entrée de la borne négative du comparateur U1 pour fournir une tension dont la valeur est proportionnelle à la tension V1, dans le rapport défini par les valeurs des deux résistance (R1, R2, ou R9, R4), et de la borne positive du comparateur est reliée à une diode ou une cellule d'alimentation (non représentées) pour définir la tension de référence V2.

Dans certains modes de réalisation, le montage intégrateur comprend une résistance R5 branchée entre le point commun du pont diviseur R1, R2 et l'entrée négative du comparateur U1 et un ensemble, résistance R8, condensateur C5 montés en série par une borne commune, est branché par l'autre borne de C5 à la sortie du comparateur U1 et l'autre borne de R8 est reliée au point commun aux deux résistances R5, R8 et à l'entrée négative de U1 les valeurs R5 et C1 sont ajustées pour régler le temps d'intervention de la disjonction avant la détérioration de la batterie (4) en cas de détection de surintensité.

Dans certains modes de réalisation, le comparateur U1 présente à sa borne de sortie une tension dont la valeur caractérise un état « non conducteur » si la tension appliquée à l'entrée de la borne négative de l'amplificateur U1 est supérieure à la valeur de la tension de référence V2 et par un état «conducteur» si la valeur de la tension appliquée à l'entrée de la borne négative de l'amplificateur U1 est inférieure à la valeur de la tension de référence V2.

Dans certains modes de réalisation, le dispositif de détection (2) comprend un condensateur C3 monté en parallèle de R2 qui combiné avec R1 forme un filtre pour filtrer des perturbations à haute fréquence.

Dans certains modes de réalisation, en parallèle de R9 est monté un ensemble série constitué d'une résistance R3, une diode D3 avec cathode orientée vers la borne positive et une diode Zener D4 avec la cathode orientée vers le point commun du pont diviseur R9, R4, un condensateur C5 reliant le point commun du pont R9, R4 à la borne négative de la batterie (4) ou de la cellule ou de l'ensemble modulaire d'éléments unitaires. Le couple (R3, C5) peut être configuré pour obtenir une constante de temps rapide et le couple (R9, C5) peut être configuré pour obtenir une constante de temps lente.

Dans certains modes de réalisation, un circuit comparateur U2 à hystérésis, disposé en aval du circuit comparateur U1, comprend un montage à hystérésis autour de l'amplificateur U2 qui reçoit à l'entrée de sa borne négative la valeur de la tension de la sortie de l'amplificateur U1.

Dans certains modes de réalisation, le comparateur U2 à hystérésis comprend des résistances R3, R4 montées en pont diviseur entre les bornes positives et négatives de la batterie (4) V1 et dont le point commun à R3 et R4 est branché à l'entrée positive du comparateur U2 et dont une résistance R6 relie la sortie de U2 à son entrée positive pour définir le seuil et l'hystérésis du circuit comparateur à hystérésis comportant l'amplificateur U2.

Dans certains modes de réalisation, le dispositif de détection (2) comprend une résistance R7 montée à la borne positive de la batterie (4), en série avec une diode D1, dans le sens passant en fonctionnement normal, et un condensateur C2 relié d'une part à la cathode de la diode et d'autre part à la borne négative de la batterie (4) pour permettre son chargement pendant le fonctionnement normal, les entrées d'alimentation des deux comparateur U1, U2 sont reliées au point commun à D1 et C2, ce point commun servant à maintenir l'alimentation des amplificateurs U1 et/ou U2 quand la tension de la batterie (4) s'écroule suite à un court-circuit pour permettre l'activation de la disjonction.

Dans certains modes de réalisation, La tension de référence V2 en entrée positive du comparateur U1 est fournie par une diode D2 qui est une Zener de 16 V. Cette diode est également reliée par une résistance R1 au point commun à D1 et C2. La cathode de la diode D2 est également reliée par un condensateur C1 à la borne négative de la batterie (4) ou ensemble modulaire d'éléments. La diode D2 peut également être remplacée par une référence de tension.

Dans certains modes de réalisation, le comparateur U2 à hystérésis comprend un condensateur (C4, [fig.1] ou C3, [fig.2]) branché en parallèle d'une résistance (R4, [fig.1] ou R3, [fig.2]) et qui combiné avec une autre résistance (R3, [fig.1] ou R2, [fig.2]) forme un filtre pour filtrer des perturbations à haute fréquence et fixer un temps minimum de disjonction.

Dans certains modes de réalisation, l'entrée positive du comparateur à hystérésis U2, [fig.2], est reliée par une résistance R2 au point commun à R3, R9 et R7.

Dans certains modes de réalisation, le dispositif de détection (2) comprend une bascule reliée à la sortie de U1 ou de U2 pour mémoriser chaque action du dispositif de détection (2) après chaque détection de décharges profondes, de surintensité et de court-circuit.

Dans certains modes de réalisation, le système (1) de gestion de batteries (BMS) communique via le dispositif de détection (2) avec un dispositif de disjonction (3) contenu dans la batterie. Le dispositif de disjonction est relié d'une part au pôle négatif de chaque bloc modulaire ou chaque batterie et d'autre part à la cosse négative de la batterie (4) et utilise au moins deux MOSFET (M1, M2).

Dans un autre mode de réalisation, le système (1) de gestion de batteries (BMS) comprend, comme illustré sur la [fig.7], un dispositif de disjonction (3) qui communique avec le dispositif de détection (2). Le dispositif de disjonction est relié d'une part au pôle négatif de chaque bloc modulaire ou chaque batterie et d'autre part à la cosse négative de la batterie (4) et utilise au moins deux MOSFET (M1, M2).

Le dispositif de disjonction (3) comprend un organe (30,31) de coupure qui peut être soit électromécanique, un relais par exemple, soit à semi-conducteurs.

De préférence, le dispositif de disjonction devra présenter une très faible consommation statique aussi bien à l'état passant (conducteur) qu'à l'état bloqué (non conducteur). Par exemple, et de manière non-limitative, un relais bistable ou un transistor MOSFET répond à cette exigence.

Dans certains modes de réalisation, le dispositif de disjonction (3) comporte un premier organe de coupure (30) dans lequel
un premier transistor à effet de champ (MOSFET) M1 connecté par sa source à la borne négative d'un jeu d'éléments unitaires, ce MOSFET M1 reçoit sur sa grille la source de tension qui pilote M1 (provenant, soit de la sortie du comparateur U1 dans la variante de la [fig.2], soit de la sortie du comparateur à hystérésis U2 dans la variante de la [fig.1]). Cette source délivre une tension choisie (par exemple 6 à 10 V) pour que M1 soit passant ;
une diode Zener D3 est branchée en opposition entre la grille et la source de M1 et un condensateur C2 pour protéger la grille du MOSFET de tensions trop élevées ou haute fréquence ; et
une diode Zener D1 montée en opposition entre la grille de M1 et le drain et avec une résistance R3 et une diode D2 en sens passant dans le sens drain grille, limitent la vitesse de commutation de M1 ; et
un circuit constitué d'une diode (classique) ou une diode Schottky D4 montée en opposition sur le drain de M1 et en série avec un condensateur C1 et une résistance R1 reliés à la borne positive de la batterie (4) pour également limiter la surtension à l'ouverture de M1. En parallèle sur la diode ou diode Schottky D4 est montée une résistance, par exemple fixe ou variable, I1, reliée d'une part à la cathode de la diode et d'autre part au drain d'un deuxième MOSFET M2 dont la source est reliée à l'anode de la diode ou diode Schottky D4. La grille de M2 est commandée par une sortie du circuit analogique ou numérique de détection pour empêcher ou couper la charge ou le courant de charge ([fig.7]). La résistance I1 permet de limiter le courant de charge.

La [fig.5] illustre le premier organe (30) de coupure et la coupure à la décharge.

La batterie (4), dans ce mode de réalisation, est en utilisation par un dispositif externe (5), par exemple et de manière non limitative un démarreur caractérisé par le couple L1-R5.

La diode D4 est passante lors de la décharge de la batterie (4). Elle doit supporter le courant de court-circuit pendant au moins 10 ms, et dissiper les pertes Joule lors d'une décharge à fort courant. Dans le cas d'une batterie (4) formée par un assemblage « 8S1P » de 8 éléments unitaires en série, avec une tension à vide de 26,4 V et une résistance interne de 0,1 Ohm (avec les connexions), le courant de court-circuit peut atteindre 264 A.

Lors de l'ouverture du MOSFET M1, il peut se produire une surtension supérieure à la tension drain-source, Vds, de M1 du fait de l'annulation du courant dans l'inductance L1. D3 et C2 qui agissent alors comme un filtre pour protéger la grille du MOSFET M1 des tensions trop élevées ou haute fréquence et éviter qu'elle soit détruite.

La diode Zener D1 avec la résistance R3 et la diode D2, permettent de limiter la vitesse de commutation de M1 afin qu'elle n'oscille pas. La commutation (en tension) est définie par l'ouverture et la fermeture du MOSFET M1, en d'autres termes sont état bloquée et son état passant.

Dans certains modes de réalisation, le dispositif de disjonction (3) comporte un second organe de coupure (31) à opto-coupleur dans lequel
un premier MOSFET M1 connecté par sa source à la borne négative d'un jeu d'éléments unitaires, la grille de ce MOSFET M1 est commandée par une tension, cette source délivrant une tension choisie pour que M1 soit toujours passant,
un circuit constitué d'une diode (classique) ou diode Schottky D4 montée en opposition sur le drain de M1, en parallèle sur la diode Schottky D4 est monté une résistance fixe I1 reliée d'une part à la cathode de la diode Zener D4 et d'autre part au drain d'un deuxième MOSFET M2 dont la source est reliée à l'anode de la diode Schottky D4, la grille de M2 étant connectée à la borne positive dudit jeu d' éléments unitaires,
une diode Zener D6 et une résistance R6 en série avec la grille de M2, la diode Zener D6 étant montée en sens passant dans le sens drain-grille,
une diode Zener D5 montée en opposition entre la grille et la source de M2 pour définir avec la diode Zener D6 la valeur de la tension au niveau de la grille de M2 et à laquelle M2 est passant,
un condensateur C5 monté entre la grille et la source de M2 et en parallèle de la diode Zener D5 pour protéger la grille de M2 des tensions haute fréquence,
un optocoupleur OP1 monté entre la grille et la source de M2 et en parallèle du condensateur C5 pour bloquer M2 en cas de dépassement de la tension ou de la température d'un élément cellulaire ou du jeu d'éléments cellulaires unitaires, le MOSFET M2 coupant alors le courant de charge.

La valeur adéquate de la résistance fixe 11, peut être obtenue en remplaçant ladite résistance par une résistance variable et en modifiant dynamiquement sa valeur (par exemple, et de manière non-limitative, par simulation).

La [fig.6], illustre le second organe (30) de coupure et la coupure à la charge.

La batterie (4), dans ce mode de réalisation, est en charge au moyen d'un dispositif externe (5), par exemple et de manière non limitative un alternateur ou un chargeur caractérisé par le couple V4 - R5.

Le dispositif externe fournit, par exemple et de manière non limitative, 28 V en fonctionnement normal, mais peut débiter une tension supérieure en cas de défaut de son régulateur. Des essais normalisés donnent une tension de 1,5 fois la tension nominale de la batterie, soit 42 V. Dans la réalité, il est possible que cette tension atteigne 80 V.

La limitation du courant de charge est assurée par la diode D4 passante dans le sens décharge, et bloquée dans le sens recharge, en parallèle avec une résistance de limitation de courant.

Ainsi, la diode D4 doit supporter le courant de court-circuit. Cela est réalisable pour une batterie modulaire, mais très difficile pour une batterie de forte capacité. En effet, une batterie non modulaire de 17 Ah, par exemple, peut fournir un courant de court-circuit de plus de 1800 A. Ainsi, la diode devrait pouvoir supporter ce courant. Des diodes, pouvant supporter ce courant n'existent pas en tant que « composant électronique » et en pratique, plusieurs composants de plus faible courant peuvent être connectés en parallèle. Mais l'équilibre des courants de diodes en parallèle est quasi impossible à réaliser, du fait que la tension directe diminue fortement avec la température. Ainsi, la diode la plus chaude supporte tout le courant, ce qui augmente encore sa température jusqu'à destruction.

Le MOSFET M1 est configuré au niveau de sa grille pour être toujours passant. La diode D4 est bloquée à la recharge, et le courant de charge passe par I1 et M2. I1 peut aussi être une association de résistances et de Polyswitchs, ou un régulateur de courant à semi-conducteurs. M2 est passant quand sa tension grille-source, V_{gs}, est à 10 V par exemple.

D6 est une diode Zener de 18 V par exemple, et D5 une diode Zener de 10 V. Ainsi, sous une tension de 28 V (tension de l'alternateur ou chargeur), D6 et D5 sont à la limite de la conduction, il n'y a pas de courant dans R6 et V_{gs} = 10 V. Les valeurs des tensions des diodes D5 et D6, permettent donc de définir la valeur de la tension grille-source du MOSFET M2. C5 protège la grille du MOSFET M2 de tensions haute fréquence.

La détection d'un défaut du chargeur comporte deux mesures: la mesure de la tension de chaque élément, et la mesure de la tension globale. Si la tension d'un élément dépasse 4 V ou si la tension globale dépasse 32 V, alors l'organe de coupure (31) à la charge est actionné. La charge est à nouveau possible quand la tension est redescendue en dessous de 26 V par exemple, grâce à un comparateur à hystérésis.

Dans la variante numérique le microprocesseur sera câblé avec la batterie pour recevoir sur ses entrées à la fois une tension représentative de la tension de chaque élément cellulaire V_{cec} constituant la batterie et aussi la mesure de tension globale V_{globale} de la batterie, disponible sur les conducteurs conduisant aux cosses extérieures de la batterie. Le programme exécutable par le microprocesseur comprendra un module de code surveillant ces deux tensions V_{cec} et V_{globale} pour après comparaison chacune avec un seuil respectif déterminé mémorisé déclencher la coupure en activant l'élément de disjonction (31), lors du dépassement de ce seuil.

En cas de dépassement de tension ou de température d'un élément unitaire, le blocage de M2 se fait grâce à l'optocoupleur OP1. En effet, l'optocoupleur OP1 comprend une diode LED (Diode électroluminescente) et un transistor. Ainsi, en cas de dépassement de tension ou de température d'un élément unitaire, un courant circule dans la LED et fait conduire le transistor. La tension grille-source, V_{gs}, du MOSFET M2 est ramenée proche de 0 V (V_{cesat} pour tension collecteur-émetteur à saturation de OP1). M2 coupe alors le courant de charge (D4 et M2 sont bloqués).

Le courant dans la diode LED de OP1 est pris au point commun entre M1 et la batterie, donc sur la tension de la batterie (4), comme illustré à la [fig.6], du fait de la déconnexion entre le 0V de la batterie et le 0V de l'alternateur ou chargeur.

Une autre variante de réalisation du dispositif de détection est possible en utilisant un circuit RC passe-bas, des composants non-linéaires (diodes et Zener) et un comparateur U1. Un montage de détection de surtension autour du comparateur U2.

Il faut noter que cette variante repose également sur la comparaison de tension par l'utilisation d'un pont diviseur R9, R4 et un comparateur U1 qui envoie directement le signal de disjonction au montage de disjonction représenté [fig.3] et 4. Le montage utilise également le même principe d'alimentation par R7,D1, C2 des comparateurs U1 et U2 pour assurer la détection même lorsque la tension de la batterie (4) s'écroule suite à un court-circuit.

Le montage à Hystérésis de U2 [fig.2] pour R5, R6, C3 est identique à celui de la [fig.1] pour R6,R4,C4. Seule la résistance R2, [fig.2] est reliée d'une part au point commun de R5,C3 et la borne positive du comparateur U2 et d'autre part au point commun à à R9 et R3.

L'entrée positive du comparateur à hystérésis U2, [fig.2], est reliée par une résistance R2 au point commun à R3, R9 et R7.

Une diode Zener D2 est reliée d'une part à l'entrée positive du comparateur à hystérésis U2 et d'autre part par une résistance R1 au point commun à D1 et C2. La cathode de la diode D2 est également reliée par un condensateur C1 à la borne négative de la batterie (4) ou ensemble modulaire d'éléments.

En parallèle de R9 est monté un ensemble série constitué d'une résistance R3, une diode D3 avec cathode orientée vers la borne positive et une diode Zener D4 avec la cathode orientée vers le point commun du pont diviseur R9, R4. Un condensateur C5 relie le point commun du pont R9, R4 à la borne négative de la batterie (4) ou de la cellule ou de l'ensemble modulaire de cellule.

En fonctionnement, comme précédemment, V1 représente la tension de la batterie (4). La tension de référence V2 en entrée positive du comparateur U1 est fournie par une diode D2 qui est une Zener de 16 V. Cette diode est également reliée par une résistance R1 au point commun à D1 et C2. La cathode de la diode D2 est également reliée par un condensateur C1 à la borne négative de la batterie (4) ou ensemble modulaire d'éléments. Ainsi la diode D2 est polarisée par R1 et filtrée par C1. La tension de la batterie (4) est divisée par R9 - R4 de sorte que quand la tension de la batterie (4) atteint lentement lentement (en décharge) la tension de point de décharge (ou EPV pour End Point Voltage en Anglais, qui est de 18 V pour une batterie de 24V et de 9V pour une batterie de 12V), la tension à l'entrée négative de U1 passe à 16 V, ce qui fait basculer le comparateur U1 de l'état « conducteur » à l'état « non conducteur » (ou de 1 à 0 en notation binaire).

En dessous de la tension de point de décharge ou EPV, la constance de temps de R9 - C5 provoque le basculement de U1 avec un retard de 1 s à 30 s typiquement. Le retard est d'autant plus bref que la tension est très en dessous de l'EPV. Pour des tensions très basses, ce qui correspond à une forte surintensité ou à un court-circuit, R3, D3 et D4 viennent en parallèle de R9, ce qui diminue le temps de basculement de U1 à moins d'une seconde (0,1 s typiquement). D4 est une Zener de 4,7 V par exemple.

Ainsi à la lecture des caractéristiques ci-dessus décrite le BMS propose :
Un seul dispositif qui assure en même temps la protection court-circuit, surintensité et décharge profonde ;
Une détection d'une surintensité pour déclenchement de coupure par une mesure de tension ;
Un courant de disjonction automatiquement adapté aux caractéristiques des éléments d'accumulateur ;
pas de shunt, pas de capteur magnétique, pas d'élément chauffant Courbe de disjonction semblable à une courbe magnéto-thermique, mais avec une bien meilleur précision ([fig.9]) ;
La courbe de disjonction suit le vieillissement des éléments d'accumulateur ;
En outre un réglage n'est pas nécessaire.

D'autres avantages découlent également du système de gestion tel que décrit dans la présente demande, on citera de manière non-exhaustive :
une très basse consommation statique;
des circuits toujours actifs, pas de mode « actif » et « veille » ;
un très haut niveau de sûreté de fonctionnement (haut MTBF) ;
une utilisation de composants standards, non stratégiques et non spécifiques à un usage pour BMS ;
Pour les modes de réalisation analogiques : Il n'y a pas de logiciel, pas de logique séquentielle, pas d'horloge, ce qui permet d'éviter des problèmes logiciels et donc une détérioration de la batterie en cas d'un problème logiciel ;
Pas d'émission électromagnétique et meilleure immunité électromagnétique (car une utilisation de composants de faible puissance).

La présente demande décrit diverses caractéristiques techniques et divers avantages avec référence aux figures et/ou aux divers modes de réalisation. Les hommes du métier comprendront que les caractéristiques techniques d'un mode de réalisation donné peuvent en fait être combinées avec des caractéristiques d'un autre mode de réalisation, sauf spécification contraire, ou sauf si la combinaison ne fournit pas une solution à au moins l'un des problèmes techniques mentionnés dans la présente demande. De plus, les caractéristiques techniques décrites dans un mode de réalisation donné peuvent être isolées des autres caractéristiques techniques de ce mode de réalisation, sauf spécification contraire.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la protection demandée, et l'invention ne doit pas être limitée aux détails donnés ci-dessus.

**Annexe :**
Il correspond à un exemple, non-limitatif, de programme d'un intégrateur numérique pour implémenter la réponse de l'intégrateur de la [fig. 4B]:

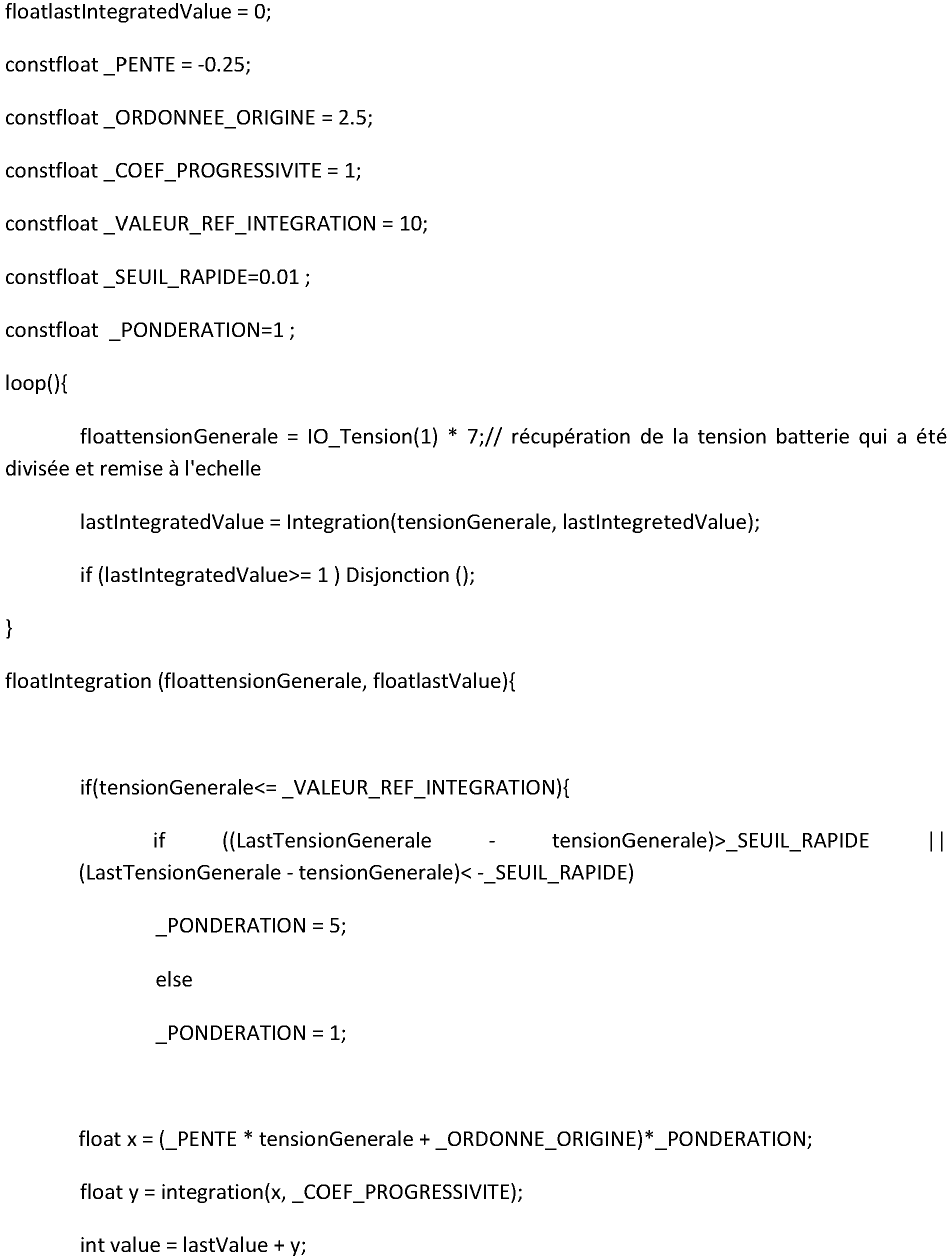

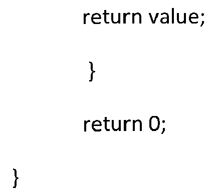

## Revendications

1. [Procédé de détection de conditions anormales de fonctionnement d'un élément unitaire de batterie (4) ou d'une pluralité de l'ensemble d'éléments unitaires comportant les étapes suivantes :
prélèvement, au point commun d'au moins deux résistances (R1, R2, R3, R4) d'un pont diviseur à au moins deux résistances (R1, R2, R3, R4), d'au moins une tension proportionnelle à la tension (V1) aux bornes de l'élément unitaire ou de l'ensemble d'éléments unitaires ;
comparaison de la tension relevée avec un seuil de référence ;
**caractérisé en ce que** ladite comparaison avec ledit seuil de référence déclenche la mise en oeuvre :
d'une évaluation de l'évolution à venir par une intégrale, évaluée de façon analogique ou de façon numérique ;
d'une comparaison de cette évaluation avec un seuil (Td) de tension de détection à partir duquel une disjonction de l'élément unitaire ou de l'ensemble d'éléments unitaires surveillés est effectuée par rapport, au moins, aux bornes de la batterie (4).

2. Procédé selon la revendication 1, **caractérisée en ce que** l'étape d'évaluation par intégrale numérique comporte:
des étapes de calcul de la pente (P) d'évolution de la courbe des tensions par utilisation d'au moins deux mesures prélevées;
au moins une étape de comparaison de la pente (P) calculée avec une valeur « Seuilrapide » mémorisée soit, pour appliquer, en cas de dépassement par la pente (P) de la valeur « Seuilrapide », un coefficient de pondération augmentant l'accélération de l'évolution de l'intégrale pour qu'elle franchisse plus vite le seuil (Td) de tension de déclenchement, soit en cas de non dépassement un coefficient de pondération sans effet d'accélération.

3. Système (1) de gestion de batteries (4) (BMS) d'accumulateurs, lesdites batteries (4) pouvant être constituées d'un élément unitaire ou de plusieurs éléments unitaires pouvant être arrangés en ensemble modulaire connectés en série, en parallèle ou en pluralité d'ensemble modulaire série associés en parallèle pour constituer une batterie (4), **caractérisé en ce que** ledit système (1) comprend des moyens adaptés pour exécuter les étapes d'un procédé de détection selon une des revendications précédentes.

4. Système (1) de gestion de batteries (4) (BMS) d'accumulateurs selon la revendication 3, **caractérisé en ce qu'**il comprend au moins :
un pont diviseur de tension à au moins deux résistances (R1, R2 ou R4, R9), pour le prélèvement d'au moins une tension proportionnelle à la tension aux bornes de l'élément unitaire ou de l'ensemble d'éléments unitaires de la batterie (4),
un dispositif de détection (2) de conditions anormales,
un dispositif de disjonction (3),
ledit dispositif de détection (2) communiquant avec le dispositif de disjonction (3) pour l'activer en cas de détection de conditions anormales, ledit dispositif de disjonction (3) étant connectable à la batterie (4) et comportant au moins deux MOSFETs.

5. Système (1) de gestion de batteries (4) (BMS) d'accumulateurs selon la revendication 4, **caractérisé en ce qu'**il comprend un microprocesseur équipé d'au moins une mémoire de stockage permettant la mémorisation d'au moins une variable de seuil «Refintégration» et une valeur de tension de détection mémorisée (Td), la mémoire contenant également le programme exécuté par le microprocesseur permettant la collecte des points de courbe de tension, les comparaisons et décisions, la mise en oeuvre des équations permettant l'intégration, le microprocesseur recevant en entrée la tension (V_{globale}) provenant du point commun du pont diviseur entre une résistance (R1) et une résistance (R2) et mémorise les mesures selon une fréquence déterminée pour observer la courbe de tension (V_{globale}), et comparer les valeurs de la courbe de tension (V_{globale}) à la valeur « Refintégration », puis à partir de la détection du franchissement du seuil « Refintégration », défini par la valeur mémorisée dans la mémoire, déclenche les calculs d'intégration de la courbe (V_{globale}) et compare les valeurs de la courbe d'intégration (V_{integ}) calculée à une valeur de tension de détection mémorisée (Td) pour activer le dispositif de disjonction (3) effectuant la coupure.

6. Système (1) de gestion de batteries (4) (BMS) d'accumulateurs selon la revendication 5, **caractérisé en ce que** la mémoire de stockage du microprocesseur comporte également la valeur d'une variable « Seuilrapide » mémorisée pour déterminer par comparaison de la variation, (dV), de la tension (V_{globale}) entre deux instants successifs (t1) et (t2) avec le « Seuilrapide » si le calcul de l'intégrale de la courbe de tension (V_{globale}) doit prendre en compte ou pas un coefficient de pondération.

7. Système (1) de gestion de batteries (4) (BMS) d'accumulateurs selon la revendication 6, **caractérisé en ce que** le calcul de l'intégrale comprend la prise en compte de variables « Pente et/ou Ordonnée » calculées par le microprocesseur à partir des données de la courbe de tension (V_{globale}) enregistrée.

8. Système (1) de gestion de batteries (4) (BMS) d'accumulateurs selon l'une des revendications 3 ou 4, **caractérisé en ce qu'**il comprend au moins autour d'un comparateur (U1) un pont diviseur (R1, R2, ou R9, R4) monté entre les bornes de l'ensemble modulaire de la batterie (4) ou d'un élément unitaire de la batterie (4) dont le point commun aux résistances est relié à l'entrée de la borne négative du comparateur (U1) pour fournir une tension dont la valeur est proportionnelle à la valeur de tension (V1) aux bornes de la batterie (4), dans le rapport défini par les valeurs des deux résistances (R1, R2, ou R9, R4), et de la borne positive du comparateur est reliée à une diode ou une cellule d'alimentation pour définir la tension de référence (V2).

9. Système (1) de gestion de batteries (4) (BMS) d'accumulateurs selon la revendication 8, **caractérisé en ce qu'**il comprend un montage intégrateur autour du comparateur (U1), le montage intégrateur comprenant :
une résistance (R5) branchée entre le point commun du pont diviseur (R1, R2) et l'entrée négative du comparateur (U1) et
un ensemble résistance (R8), condensateur (C1), montés en série par une borne commune, branché par l'autre borne de (C1) à la sortie du comparateur (U1), l'autre borne de (R8) étant reliée au point commun aux deux résistances (R5, R8) et à l'entrée négative de (U1), les valeurs (R5) et (C1) étant ajustées pour régler le temps d'intervention de la disjonction avant la détérioration de la batterie (4) en cas de détection de surintensité.

10. Système (1) de gestion de batteries (4) (BMS) d'accumulateurs selon la revendication 9, **caractérisé en ce qu'**une diode (D2) est branchée en parallèle sur la résistance (R5), avec sa cathode reliée au point commun du pont diviseur pour changer la constante de temps d'intégration du montage intégrateur dans le cas d'une surintensité ou un court-circuit.

11. Système (1) de gestion de batteries (4) (BMS) d'accumulateurs une des revendications 8 à 10, **caractérisé en ce que** le comparateur (U1) présente à sa borne de sortie une tension dont la valeur caractérise un état « non conducteur » si la tension appliquée à l'entrée de la borne négative de l'amplificateur (U1) est supérieure à la valeur de la tension de référence (V₂) et par un état «conducteur» si la valeur de la tension appliquée à l'entrée de la borne négative de l'amplificateur (U1) est inférieure à la valeur de la tension de référence (V₂).

12. Système (1) de gestion de batteries (4) (BMS) d'accumulateurs selon la revendication 4, **caractérisé en ce que** le dispositif de détection (2) comprend un condensateur (C3) monté en parallèle de R2 qui combiné avec (R1) forme un filtre pour filtrer des perturbations à haute fréquence.

13. Système (1) de gestion de batteries (4) (BMS) d'accumulateurs selon la revendication 8, **caractérisé en ce qu'**en parallèle de (R9) est monté
un ensemble série constitué d'une résistance (R3), une diode D3 avec cathode orientée vers la borne positive et une diode Zener D4 avec la cathode orientée vers le point commun du pont diviseur (R9, R4),
un condensateur (C5) reliant le point commun du pont (R9, R4) à la borne négative de la batterie (4) ou de la cellule ou de l'ensemble modulaire d'éléments unitaires.

14. Système (1) de gestion de batteries (4) (BMS) d'accumulateurs selon les revendications 8 à 13, **caractérisé en ce qu'**un circuit comparateur (U2) à hystérésis, disposé en aval du circuit comparateur (U1), comprend un montage à hystérésis autour de l'amplificateur (U2) qui reçoit à l'entrée de sa borne négative la valeur de la tension de la sortie de l'amplificateur (U1).

15. Système (1) de gestion de batteries (4) (BMS) d'accumulateurs selon la revendication 14, **caractérisé en ce que** comparateur (U2) à hystérésis comprend des résistances (R3), (R4) montées en pont diviseur entre les bornes positives et négatives de la batterie (4) (V1) et dont le point commun à (R3) et (R4) est branché à l'entrée positive du comparateur (U2) et dont une résistance (R6) relie la sortie de (U2) à son entrée positive pour définir le seuil et l'hystérésis du circuit comparateur à hystérésis comportant l'amplificateur (U2).

16. Système (1) de gestion de batteries (4) (BMS) d'accumulateurs selon une des revendications 8 à 15, **caractérisé en ce que** le dispositif de détection (2) comprend une résistance (R7) montée à la borne positive de la batterie (4), en série avec une diode (D1), dans le sens passant en fonctionnement normal, et un condensateur (C2) relié d'une part à la cathode de la diode et d'autre part à la borne négative de la batterie (4) pour permettre son chargement pendant le fonctionnement normal, les entrées d'alimentation des deux comparateur (U1), (U2) sont reliées au point commun à (D1) et (C2), ce point commun servant à maintenir l'alimentation des amplificateurs (U1) et/ou (U2) quand la tension de la batterie (4) s'écroule suite à un court-circuit pour permettre l'activation de la disjonction.

17. Système (1) de gestion de batteries (4) (BMS) d'accumulateurs selon une de revendications 8 à 16, **caractérisé en ce que** la tension de référence (V2) en entrée positive du comparateur (U1) est fournie par une diode Zener (D2), ladite diode Zener étant reliée par une résistance (R1) au point commun à (D1) et (C2), la cathode de la diode Zener (D2) étant également reliée par un condensateur (C1) à la borne négative de la batterie (4) ou ensemble modulaire d'éléments.

18. Système (1) de gestion de batteries (4) (BMS) d'accumulateurs selon une des revendications 14 à 17, **caractérisé en ce que** le comparateur (U2) à hystérésis comprend un condensateur (C4, C3) branché en parallèle d'une résistance (R4,R3) et qui combiné avec une autre résistance (R3, R2) forme un filtre pour filtrer des perturbations à haute fréquence et fixer un temps minimum de disjonction.

19. Système (1) de gestion de batteries (4) (BMS) d'accumulateurs selon une des revendications 14 à 17 ou 18, **caractérisé en ce que** l'entrée positive du comparateur à hystérésis (U2), est reliée par une résistance (R2) au point commun à (R3), R9 et (R7).

20. Système (1) de gestion de batteries (4) (BMS) d'accumulateurs selon une des revendications 8 à 19, **caractérisé en ce que** le dispositif de détection (2) comprend une bascule reliée à la sortie de (U1) ou de (U2) pour mémoriser chaque action du dispositif de détection (2) après chaque détection de décharges profondes, de surintensité et de court-circuit.

21. Système (1) de gestion de batteries (4) (BMS) d'accumulateurs selon la revendication 4, **caractérisé en ce que** le dispositif de disjonction (3) comporte un organe de coupure (30) dans lequel
un premier MOSFET (M1) est connecté par sa source à la borne négative d'un jeu d'éléments unitaires, ledit MOSFET (M1) recevant sur sa grille la source de tension qui pilote (M1), ladite source délivrant une tension choisie pour que (M1) soit passant,
une diode Zener (D3) branchée en opposition entre la grille et la source de (M1) et un condensateur (C2) protègent la grille du MOSFET de tensions trop élevées ou haute fréquence et
une diode Zener (D1) montée en opposition entre la grille de (M1) et le drain et avec une résistance (R3) et une diode (D2) en sens passant dans le sens drain grille, limitent la vitesse de commutation de (M1) et
un circuit constitué d'une diode Schottky (D4) montée en opposition sur le drain de (M1) et en série avec un condensateur (C1) et une résistance (R1) reliés à la borne positive de la batterie (4) pour limiter la surtension à l'ouverture de (M1), en parallèle sur la diode Schottky (D4) est monté une résistance fixe (11) reliée d'une part à la cathode de la diode et d'autre part au drain d'un deuxième MOSFET (M2) dont la source est reliée à l'anode de la diode Schottky (D4), la grille de (M2) étant commandée par une sortie du circuit de détection pour empêcher la charge.

22. Système (1) de gestion de batteries (4) (BMS) d'accumulateurs selon la revendication 4, **caractérisé en ce que** le dispositif de disjonction (3) comporte un second organe de coupure (31) dans lequel
un premier MOSFET (M1) connecté par sa source à la borne négative d'un jeu d'éléments unitaires, la grille de ce MOSFET (M1) est commandée par une tension, cette source délivrant une tension choisie pour que (M1) soit toujours passant,
un circuit constitué d'une diode Schottky (D4) montée en opposition sur le drain de (M1), en parallèle sur la diode Schottky (D4) est monté une résistance fixe I1 reliée d'une part à la cathode de la diode Schottky (D4) et d'autre part au drain d'un deuxième MOSFET (M2) dont la source est reliée à l'anode de la diode Schottky (D4), la grille de (M2) étant connectée à la borne positive dudit jeu d'éléments unitaires,
une diode Zener (D6) et une résistance (R6) en série avec la grille de (M2), la diode Zener (D6) étant montée en sens passant dans le sens drain-grille,
une diode Zener (D5) montée en opposition entre la grille et la source de (M2) pour définir avec la diode Zener (D6) la valeur de la tension au niveau de la grille de (M2) et à laquelle (M2) est passant,
un condensateur (C5) monté entre la grille et la source de (M2) et en parallèle de la diode Zener (D5) pour protéger la grille de (M2) des tensions haute fréquence,
un optocoupleur (OP1) monté entre la grille et la source de (M2) et en parallèle du condensateur (C5) pour bloquer (M2) en cas de dépassement de la tension ou de la température d'un élément du jeu d'éléments unitaires, le MOSFET (M2) coupant alors le courant de charge.

## Patentansprüche

1. Verfahren zum Erfassen anormaler Betriebsbedingungen eines Batterie-Einzelelements (4) oder einer Vielzahl der Einheit von Einzelelementen, das die folgenden Schritte umfasst:
Erheben am gemeinsamen Punkt von mindestens zwei Widerständen (R1, R2, R3, R4) einer Teilerbrücke mit mindestens zwei Widerständen (R1, R2, R3, R4) mindestens einer Spannung, die zu der Spannung (V1) an den Klemmen des Einzelelements oder der Einheit von Einzelelementen proportional ist;
Vergleich der erhobenen Spannung mit ein Referenzschwellenwert;
**dadurch gekennzeichnet, dass** der Vergleich mit dem Referenzschwellenwert die Umsetzung auslöst von:
einer Bewertung der zukünftigen Entwicklung durch ein Integral, das auf analoge Weise oder auf digitale Weise bewertet wird;
einem Vergleich dieser Bewertung mit einem Erfassungsspannungs-Schwellenwert (Td), ab dem ein Abschalten des überwachten Einzelelements oder der überwachten Einheit von Einzelelementen in Bezug mindestens auf die Klemmen der Batterie (4) erfolgt.

2. Verfahren nach Anspruch 1, **dadurch gekennzeichnet, dass** der Bewertungsschritt durch digitales Integral das Folgendes umfasst:
Berechnungsschritte der Entwicklungssteigung (P) der Kurve der Spannungen durch Verwendung von mindestens zwei erhobenen Messungen;
mindestens einen Vergleichsschritt der berechneten Steigung (P) mit einem gespeicherten "Schnellschwellenwert", um entweder im Fall des Überschreitens durch die Steigung (P) des Werts "Schnellschwellenwert" einen Gewichtungskoeffizienten anzuwenden, der die Beschleunigung der Entwicklung des Integrals erhöht, damit sie den Auslösungsspannungs-Schwellenwert (Td) schneller überschreitet, oder im Fall des Nichtüberschreitens einen Gewichtungskoeffizienten ohne Beschleunigungsauswirkung.

3. System (1) zur Verwaltung von Batterien (4) (BMS) von Akkumulatoren, wobei die Batterien (4) aus einem Einzelelement oder mehreren Einzelelementen bestehen können, die als modulare, in Reihe, parallel geschaltete Einheit verbunden eingerichtet werden können, oder als eine Vielzahl modularer Einheit in Reihe, die parallel zugeordnet sind, um eine Batterie (4) zu bilden, **dadurch gekennzeichnet, dass** das System (1) Mittel umfasst, die dazu angepasst sind, die Schritte eines Erfassungsverfahrens nach einem der vorstehenden Ansprüche auszuführen.

4. System (1) zur Verwaltung von Batterien (4) (BMS) von Akkumulatoren nach Anspruch 3, **dadurch gekennzeichnet, dass** es mindestens Folgendes umfasst:
eine Spannungsteilerbrücke mit mindestens zwei Widerständen (R1, R2 oder R4, R9) zum Erheben mindestens einer Spannung, die zu der Spannung an den Klemmen des Einzelelements oder der Einheit von Einzelelementen der Batterie (4) proportional ist,
eine Erfassungsvorrichtung (2) anormaler Bedingungen, eine Abschaltvorrichtung (3),
wobei die Erfassungsvorrichtung (2) mit der Abschaltvorrichtung (3) in Kommunikation steht, um sie bei Erfassung anormaler Bedingungen zu aktivieren, wobei die Abschaltvorrichtung (3) an die Batterie (4) angeschlossen werden kann und mindestens zwei MOSFETs umfasst.

5. System (1) zur Verwaltung von Batterien (4) (BMS) von Akkumulatoren nach Anspruch 4, **dadurch gekennzeichnet, dass** es einen Mikroprozessor umfasst, der mit mindestens einem Speicher ausgerüstet ist, der das Speichern mindestens einer "Reintegration"-Schwellenvariablen und eines gespeicherten Erfassungsspannungswerts (Td) erlaubt, wobei der Speicher auch das Programm enthält, das von dem Mikroprozessor ausgeführt wird, das das Sammeln der Spannungskurvenstellen, die Vergleiche und Entscheidungen erlaubt, wobei die Umsetzung der Gleichungen die Integration erlaubt, der Mikroprozessor am Eingang eine Spannung (V_{globale}) empfängt, die von einem gemeinsamen Punkt der Teilerbrücke zwischen einem Widerstand (R1) und einem Widerstand (R2) stammt, und die Messungen gemäß einer bestimmten Häufigkeit speichert, um die Spannungskurve (V_{globale}) zu beobachten, und die Werte der Spannungskurve (V_{globale}) mit dem Wert "Reintegration" zu vergleichen, dann ausgehend von der Erfassung des Überschreitens des Schwellenwerts "Reintegration", der von dem in dem Speicher gespeicherten Wert definiert ist, die Integrationsberechnungen der Kurve (V_{globale}) auslöst und die Werte der berechneten Integrationskurve (V_{integ}) mit einem gespeicherten Erfassungsspannungswert (Td) vergleicht, um die Abschaltvorrichtung (3), die die Unterbrechung vornimmt, zu aktivieren.

6. System (1) zur Verwaltung von Batterien (4) (BMS) von Akkumulatoren nach Anspruch 5, **dadurch gekennzeichnet, dass** der Speicher des Mikroprozessors auch den Wert einer gespeicherten Variablen "Schnellschwellenwert" umfasst, um durch Vergleich der Variation (dV) der Spannung (V_{globale}) zwischen zwei aufeinanderfolgenden Augenblicken (t1) und (t2) ) mit dem "Schnellschwellenwert" zu bestimmen, falls die Berechnung des Integrals der Spannungskurve (V_{globale}) einen Gewichtungskoeffizienten berücksichtigen muss oder nicht.

7. System (1) zur Verwaltung von Batterien (4) (BMS) von Akkumulatoren nach Anspruch 6, **dadurch gekennzeichnet, dass** die Berechnung des Integrals die Berücksichtigung von Variablen "Steigung und/oder Ordinate" umfasst, die von dem Mikroprozessor ausgehend von Daten der aufgezeichneten Spannungskurve (V_{globale}) berechnet werden.

8. System (1) zur Verwaltung von Batterien (4) (BMS) von Akkumulatoren nach einem der Ansprüche 3 oder 4, **dadurch gekennzeichnet, dass** es mindestens um einen Komparator (U1) eine Teilerbrücke (R1, R2 oder R9, R4) umfasst, die zwischen den Klemmen der modularen Batterieeinheit (4) oder eines Einzelelements der Batterie (4) geschaltet ist, deren gemeinsamer Punkt an den Widerständen mit dem Eingang der negativen Klemme des Komparators (U1) verbunden ist, um eine Spannung zu liefern, deren Wert zu dem Spannungswert (V1) an den Klemmen der Batterie (4) in dem Verhältnis proportional ist, das von den Werten der zwei Widerstände (R1, R2 oder R9, R4) definiert ist, und die positive Klemme des Komparators mit einer Diode oder einer Versorgungszelle verbunden ist, um die Referenzspannung (V2) zu definieren.

9. System (1) zur Verwaltung von Batterien (4) (BMS) von Akkumulatoren nach Anspruch 8, **dadurch gekennzeichnet, dass** es eine Integratorschaltung um den Komparator (U1) umfasst, wobei die Integratorschaltung Folgendes umfasst:
einen Widerstand (R5), der zwischen dem gemeinsamen Punkt der Teilerbrücke (R1, R2) und dem negativen Eingang des Komparators (U1) angeschlossen ist, und
eine Einheit aus Widerstand (R8), Kondensator (C1), die durch eine gemeinsame Klemme in Reihe geschaltet sind, die durch die andere Klemme von (C1) an den Ausgang des Komparators (U1) angeschlossen sind, wobei die andere Klemme von (R8) mit einem gemeinsamen Punkt mit den zwei Widerständen (R5, R8) und am dem negativen Eingang von (U1) verbunden ist, wobei die Werte (R5) und (C1) eingestellt werden, um die Eingriffszeit der Abschaltung vor der Beschädigung der Batterie (4) im Fall von Überstromerfassung zu regeln.

10. System (1) zur Verwaltung von Batterien (4) (BMS) von Akkumulatoren nach Anspruch 9, **dadurch gekennzeichnet, dass** eine Diode (D2) parallel auf dem Widerstand (R5) angeschlossen ist, mit ihrer Kathode mit dem gemeinsamen Punkt der Teilerbrücke verbunden, um die Integrationszeitkonstante der Integratorschaltung im Fall eines Überstroms oder eines Kurzschlusses zu ändern.

11. System (1) zur Verwaltung von Batterien (4) (BMS) von Akkumulatoren nach einem der Ansprüche 8 bis 10, **dadurch gekennzeichnet, dass** der Komparator (U1) an seiner Ausgangsklemme eine Spannung aufweist, deren Wert einen "nicht leitenden" Zustand charakterisiert, falls die Spannung, die an dem Eingang der negativen Klemm des Verstärkers (U1) angelegt wird, größer ist als der Wert der Referenzspannung (V2), und durch einen "leitenden" Zustand, falls der Wert der Spannung, die an dem Eingang der negativen Klemme des Verstärkers (U1) angelegt wird, kleiner ist als der Wert der Referenzspannung (V2).

12. System (1) zur Verwaltung von Batterien (4) (BMS) von Akkumulatoren nach Anspruch 4, **dadurch gekennzeichnet, dass** die Erfassungsvorrichtung (2) einen Kondensator (C3) umfasst, der parallel zu R2 geschaltet ist, der, kombiniert mit (R1), ein Filter zu Filtern der hochfrequente Störungen bildet.

13. System (1) zur Verwaltung von Batterien (4) (BMS) von Akkumulatoren nach Anspruch 8, **dadurch gekennzeichnet, dass** parallel zu (R9) eine serielle Einheit geschaltet ist, die aus einem Widerstand (R3), einer Diode (D3) mit Kathode zu der positiven Klemme gerichtet, und einer Zenerdiode (D4) mit der Kathode zu dem gemeinsamen Punkt der Teilerbrücke (R9, R4) gerichtet, geschaltet ist, wobei ein Kondensator (C5) den gemeinsamen Punkt der Teilerbrücke (R9, R4) mit der negativen Klemme der Batterie (4) oder der Zelle oder der modularen Einheit von Einzelelementen verbindet.

14. System (1) zur Verwaltung von Batterien (4) (BMS) von Akkumulatoren nach einem der Ansprüche 8 bis 13, **dadurch gekennzeichnet, dass** eine Vergleichshystereseschaltung (U2), die der Komparatorschaltung (U1) nachgeschaltet angeordnet ist, eine Hystereseschaltung um den Verstärker (U2) umfasst, der an dem Eingang seiner negativen Klemme den Spannungswert des Ausgangs des Verstärkers (U1) empfängt.

15. System (1) zur Verwaltung von Batterien (4) (BMS) von Akkumulatoren nach Anspruch 14, **dadurch gekennzeichnet, dass** der Komparator (U2) mit Hysterese Widerstände (R3), (R4) umfasst, die als Teilerbrücke zwischen der positiven und der negativen Klemme der Batterie (4) (V1) geschaltet sind, und deren Punkt, der (R3) und (R4) gemeinsam ist, an dem positiven Eingang des Komparators (U2) angeschlossen, und wovon ein Widerstand (R6) den Ausgang von (U2) mit seinem positiven Eingang verbindet, um den Schwellenwert und die Hysterese der Vergleichshystereseschaltung, die den Verstärker (U2) umfasst, zu definieren.

16. System (1) zur Verwaltung von Batterien (4) (BMS) von Akkumulatoren nach einem der Ansprüche 8 bis 15, **dadurch gekennzeichnet, dass** die Erfassungsvorrichtung (2) einen Widerstand (R7) umfasst, der an der positiven Klemme der Batterie (4) in Reihe mit einer Diode (D1) in der leitenden Richtung bei normalem Betrieb geschaltet ist, und einen Kondensator (C2), der einerseits mit der Kathode der Diode und andererseits mit der negativen Klemme der Batterie (4) verbunden ist, um ihr Laden während des normalen Betriebs zu erlauben, wobei die Versorgungseingänge der zwei Komparatoren (U1), (U2) mit dem Punkt verbunden sind, der (D1) und (C2) gemeinsam ist, wobei dieser gemeinsame Punkt dazu dient, die Versorgung der Verstärker (U1) und/oder (U2) aufrechtzuerhalten, wenn die Spannung der Batterie (4) im Anschluss an einen Kurzschluss zusammenbricht, um die Aktivierung der Abschaltung zu erlauben.

17. System (1) zur Verwaltung von Batterien (4) (BMS) von Akkumulatoren nach einem der Ansprüche 8 bis 16, **dadurch gekennzeichnet, dass** die Referenzspannung (V2) am positiven Eingang des Komparators (U1) von einer Zenerdiode (D2) geliefert wird, wobei die Zenerdiode durch einen Widerstand (R1) mit dem Punkt verbunden ist, der (D1) und (C2) gemeinsam ist, wobei die Kathode der Zenerdiode (D2) ebenfalls durch einen Kondensator (C1) mit der negativen Klemme der Batterie (4) oder der modularen Einheit von Elementen verbunden ist.

18. System (1) zur Verwaltung von Batterien (4) (BMS) von Akkumulatoren nach einem der Ansprüche 14 bis 17, **dadurch gekennzeichnet, dass** der Komparator (U2) mit Hysterese einen Kondensator (C4, C3) umfasst, der parallel zu einem Widerstand (R4, R3) angeschlossen ist und der, kombiniert mit einem anderen Widerstand (R3, R2), ein Filter bildet, um hochfrequente Störungen zu filtern und eine Mindestabschaltzeit festzulegen.

19. System (1) zur Verwaltung von Batterien (4) (BMS) von Akkumulatoren nach einem der Ansprüche 14 bis 17 oder 18, **dadurch gekennzeichnet, dass** der positive Eingang des Komparators mit Hysterese (U2) durch einen Widerstand (R2) mit dem Punkt, der (R3), (R9) und (R7) gemeinsam ist, verbunden ist.

20. System (1) zur Verwaltung von Batterien (4) (BMS) von Akkumulatoren nach einem der Ansprüche 8 bis 19, **dadurch gekennzeichnet, dass** die Erfassungsvorrichtung (2) einen Flip-Flop umfasst, der mit dem Ausgang von (U1) oder von (U2) verbunden ist, um jede Aktion der Erfassungsvorrichtung (2) nach jeder Erfassung Tiefenentladungen, Überstrom oder Kurzschluss zu speichern.

21. System (1) zur Verwaltung von Batterien (4) (BMS) von Akkumulatoren nach Anspruch 4, **dadurch gekennzeichnet, dass** die Abschaltvorrichtung (3) ein Trendelement (30) umfasst, in dem ein erster MOSFET (M1) über seine Source mit der negativen Klemme eines Satzes von Einzelelementen verbunden ist, wobei der MOSFET (M1) auf seinem Gate die Spannungsquelle empfängt, die (M1) steuert, wobei die Source eine Spannung abgibt, die ausgewählt ist, damit (M1) leitend ist,
eine Zenerdiode (D3), die in Gegenrichtung zwischen dem Gate und der Source von (M1) angeschlossen ist, und ein Kondensator (C2) das Gate des MOSFET vor zu hohen Spannungen oder Hochfrequenzen schützen und
eine Zenerdiode (D1), die zwischen dem Gate von (M1) und dem Drain in Gegenrichtung geschaltet ist, und mit einem Widerstand (R3) und einer Diode (D2) in leitender Richtung in der Drain-Gate-Richtung die Umschaltgeschwindigkeit von (M1) begrenzt und
eine Schaltung, die aus einer Schottky-Diode (D4) besteht, die in Gegenrichtung auf dem Drain von (M1) und in Reihe mit einem Kondensator (C1) geschaltet ist, und einem Widerstand (R1), die mit der positiven Klemme der Batterie (4) verbunden sind, um die Überspannung beim Öffnen von (M1) zu begrenzen, parallel auf der Schottky-Diode (D4) ein fixer Widerstand (11) geschaltet ist, der einerseits mit der Kathode der Diode und andererseits mit dem Drain eines zweiten MOSFET (M2) verbunden ist, dessen Source mit der Anode der Schottky-Diode (D4) verbunden ist, wobei das Gate von (M2) durch einen Ausgang der Erfassungsschaltung gesteuert wird, um das Laden zu verhindern.

22. System (1) zur Verwaltung von Batterien (4) (BMS) von Akkumulatoren nach Anspruch 4, **dadurch gekennzeichnet, dass** die Abschaltvorrichtung (3) ein zweites Trennelement (31) umfasst, in dem ein erster MOSFET (M1) über seine Source mit der negativen Klemme eines Satzes von Einzelelementen verbunden ist, wobei das Gate des MOSFET (M1) von einer Spannung gesteuert wird, wobei diese Source eine Spannung abgibt, die ausgewählt ist, damit (M1) immer leitend ist,
eine Schaltung, die aus einer Schottky-Diode (D4) besteht, die in Gegenrichtung auf dem Drain von (M1) geschaltet ist, parallel auf der Schottky-Diode (D4) ein fixer Widerstand (11) geschaltet ist, der einerseits mit der Kathode der Schottky-Diode (D4) und andererseits mit dem Drain eines zweiten MOSFET (M2) verbunden ist, dessen Source mit der Anode der Schottky-Diode (D4) verbunden ist, wobei das Gate von (M2) mit der positiven Klemme des Satzes von Einzeleinheiten verbunden ist.
eine Zenerdiode (D6) und einen Widerstand (R6) in Reihe mit dem Gate von (M2) geschaltet, wobei die Zenerdiode (D6) in Durchlassrichtung in der Drain-Gate-Errichtung geschaltet ist, eine Zenerdiode (D5), die in Gegenrichtung zwischen dem Gate und der Source von (M2) geschaltet ist, um mit der Zenerdiode (D6) den Spannungswert auf der Ebene des Gates von (M2) zu definieren und an dem (M2) leitend ist,
einen Kondensator (C5), der zwischen dem Gate und der Source von (M2) und parallel zu der Zenerdiode (D5) geschaltet ist, um das Gate von (M2) vor Hochfrequenzspannungen zu schützen,
einen Optokoppler (OP1), der zwischen dem Gate und der Source von (M2) und dem Kondensator (C5) parallel geschaltet ist, um (M2) bei Überschreitung der Spannung oder der Temperatur eines Elements des Satzes von Einzelelementen zu blockieren, wobei der MOSFET (M2) dann den Ladestrom unterbricht.

## Claims

1. [Method for detecting abnormal operating conditions of a single battery element or of a plurality of the set of single elements comprising the following steps:
sampling, at the common point of at least two resistors of a divider bridge with at least two resistors, at least one voltage proportional to the voltage at the terminals of the single element or of the set of single elements;
comparing the detected voltage with a reference threshold;
**characterized in that** said comparison with said reference threshold triggers the implementation of:
an evaluation of the evolution to come by an integral, evaluated analogically or digitally;
a comparison of this evaluation with a detection voltage threshold (Td) from which a disconnection of the single element or of the set of monitored single elements is carried out with respect, at least, to the terminals of the battery.

2. Method according to claim 1, **characterized in that** the step of evaluation by digital integral comprises:
steps for calculating the evolution slope (P) of the voltage curve by using at least two measurements taken;
at least one step of comparing the calculated slope with a stored "RapidThreshold" value, i.e., if the slope exceeds the "RapidThreshold" value, applying a weight coefficient increasing the acceleration of the evolution of the integral so that it crosses the trigger voltage threshold (Td) more quickly, or if it is not exceeded, a weight coefficient without acceleration effect.

3. Battery management system (BMS) (1) for accumulators, said batteries being capable of being constituted by a single element or several single elements that can be arranged in a modular assembly and connected in series, in parallel or in a plurality of series modular assemblies associated in parallel to form a battery (4), **characterized in that** said system comprises means suitable for performing the steps of a detection method according to one of the preceding claims.

4. Battery management system (BMS) (1) for accumulators according to claim 3, **characterized in that** it comprises at least:
a voltage divider bridge with at least two resistors (R1, R2 or R4, R9), for sampling at least one voltage proportional to the voltage at the terminals of the single element or of the set of single elements of the battery,
a detection device (2) for detecting abnormal conditions,
a disconnection device (3),
said detection device (2) communicating with the disconnection device (3) to activate it in the event of detection of abnormal conditions, said disconnection device being connectable to the battery (4) and comprising at least two MOSFETs.

5. Battery management system (BMS) (1) for accumulators according to claim 4, **characterized in that** it comprises a microprocessor equipped with at least one storage memory allowing the storage of at least one "Refintegration" threshold variable and a stored detection voltage value (Td), the memory also containing the program executed by the microprocessor allowing the collection of the voltage curve points, the comparisons and decisions, the implementation of the equations allowing the integration, the microprocessor receiving as input the voltage (V_{global}) coming from the common point of the divider bridge between a resistor R1 and a resistor R2 and storing the measurements according to a determined frequency to observe the voltage curve (V_{global}), and comparing the values of the voltage curve (V_{global}) with the "Refintegration" value, then when crossing of the "Refintegration" threshold is detected, said threshold being defined by the value stored in the memory, triggering the integration calculations of the curve (V_{global}) and comparing the values of the calculated integration curve (V_{integ}) with a stored detection voltage value (Td) to activate the disconnection device effecting the cut-off.

6. Battery management system (BMS) (1) for accumulators according to claim 5, **characterized in that** the storage memory of the microprocessor also comprises the value of a "RapidThreshold" variable stored in order to determine, by comparing the variation (dV) of the voltage (V_{global}) between two successive instants (t1) and (t2) with the "RapidThreshold," whether the calculation of the integral of the voltage curve (V_{global}) must take a weight coefficient into account or not.

7. Battery management system (BMS) (1) for accumulators according to claim 6, **characterized in that** the calculation of the integral comprises taking into account the "Slope and/or Ordinate" variables calculated by the microprocessor from the data of the recorded voltage curve (V_{global}).

8. Battery management system (BMS) (1) for accumulators according to one of claims 3 or 4, **characterized in that** it comprises at least around one comparator (U1), a divider bridge (R1, R2, or R9, R4) mounted between the terminals of the modular assembly of the battery (4) or of a single element of the battery (4) whose common point with the resistors is connected to the input of the negative terminal of the comparator (U1) to supply a voltage whose value is proportional to the voltage value (V1) at the terminals of the battery, in the ratio defined by the values of the two resistors (R1, R2 or R9, R4), and the positive terminal of the comparator is connected to a diode or a supply cell to define the reference voltage (V2).

9. Battery management system (BMS) (1) for accumulators according to claim 8, **characterized in that** it comprises an integrator circuit around the comparator (U1), the integrator circuit comprising:
a resistor (R5) connected between the common point of the divider bridge (R1, R2) and the negative input of the comparator (U1), and
a resistor (R8), capacitor (C1) set mounted in series by a common terminal, connected by the other terminal of (C1) to the output of the comparator (U1), the other terminal of (R8) being connected to the common point of the two resistors (R5, R8) and to the negative input of (U1), the values (R5) and (C1) being adjusted to set the intervention time of the disconnection before the deterioration of the battery in the event of overcurrent detection.

10. Battery management system (BMS) (1) for accumulators according to claim 9, **characterized in that** a diode (D2) is connected in parallel to resistor (R5), with its cathode connected to the common point of the divider bridge to change the integration time constant of the integrator circuit in the event of an overcurrent or a short circuit.

11. Battery management system (BMS) (1) for accumulators according to one of claims 8 to 10, **characterized in that** the comparator (U1) has, at its output terminal, a voltage whose value characterizes a "non-conductive" state if the voltage applied to the input of the negative terminal of the amplifier (U1) is greater than the value of the reference voltage (V₂) and a "conductive" state if the value of the voltage applied to the input of the negative terminal of the amplifier (U1) is lower than the value of the reference voltage (V₂).

12. Battery management system (BMS) (1) for accumulators according to claim 4, **characterized in that** the detection device (2) comprises a capacitor (C3) mounted in parallel with (R2) that, combined with (R1), forms a filter to filter out high-frequency disturbances.

13. Battery management system (BMS) (1) for accumulators according to claim 8, **characterized in that** mounted in parallel with (R9) are
a series assembly consisting of a resistor (R3), a diode (D3) with the cathode oriented toward the positive terminal and a Zener diode (D4) with the cathode oriented toward the common point of the divider bridge (R9, R4),
a capacitor (C5) connecting the common point of the bridge (R9, R4) to the negative terminal of the battery (4) or of the cell or of the modular assembly of single elements.

14. Battery management system (BMS) (1) for accumulators according to claims 8 to 13, **characterized in that** a comparator circuit (U2) with hysteresis, disposed downstream of the comparator circuit (U1), comprises a hysteresis assembly around the amplifier (U2) that receives, at the input of its negative terminal, the value of the voltage of the output of the amplifier (U1).

15. Battery management system (BMS) (1) for accumulators according to claim 14, **characterized in that** the hysteresis comparator (U2) comprises resistors (R3, R4) mounted as a divider bridge between the positive and negative terminals of the battery (4) (V1) and whose point common to (R3) and (R4) is connected to the positive input of the comparator (U2) and a resistor (R6) of which connects the output of (U2) to its positive input to define the threshold and the hysteresis of the hysteresis comparator circuit comprising the amplifier (U2).

16. Battery management system (BMS) (1) for accumulators according to one of claims 8 to 15, **characterized in that** the detection device (2) comprises a resistor (R7) connected to the positive terminal of the battery (4), in series with a diode (D1), in the forward direction in normal operation, and a capacitor (C2) connected on the one hand to the cathode of the diode and on the other hand to the negative terminal of the battery (4) to allow it to be charged during normal operation; the supply inputs of the two comparators (U1), (U2) are connected to the point common to (D1) and (C2), this common point being used to maintain the supply of the amplifiers (U1) and/or (U2) when the battery (4) voltage collapses following a short circuit to allow the activation of the disconnection.

17. Battery management system (BMS) (1) for accumulators according to one of claims 8 to 16, **characterized in that** the reference voltage (V2) at the positive input of the comparator (U1) is provided by a Zener diode (D2), said Zener diode being connected by a resistor (R1) to the point common to (D1) and (C2), the cathode of the Zener diode (D2) also being connected by a capacitor (C1) to the negative terminal of the battery (4) or modular set of elements.

18. Battery management system (BMS) (1) for accumulators according to one of claims 14 to 17, **characterized in that** the hysteresis comparator (U2) comprises a capacitor (C4, C3) connected in parallel with a resistor (R4, R3) and which, combined with another resistor (R3, R2), forms a filter to filter out high-frequency disturbances and set a minimum tripping time.

19. Battery management system (BMS) (1) for accumulators according to one of claims 14 to 17 or 18, **characterized in that** the positive input of the hysteresis comparator (U2) is connected by a resistor (R2) to the common point to (R3), (R9) and (R7).

20. Battery management system (BMS) (1) for accumulators according to one of claims 8 to 19, **characterized in that** the detection device (2) comprises a flip-flop connected to the output of (U1) or (U2) to store each action of the detection device (2) after each detection of deep discharges, overcurrent discharges and short-circuit discharges.

21. Battery management system (BMS) (1) for accumulators according to claim 4, **characterized in that** the disconnection device (3) comprises a switching device (30) in which
a first MOSFET (M1) is connected by its source to the negative terminal of a set of single elements, said MOSFET (M1) receiving, on its gate, the voltage source that drives M1, said source delivering a voltage chosen so that (M1) is on,
a Zener diode (D3), connected in opposition between the gate and the source of (M1), and a capacitor (C2) protect the gate of the MOSFET from excessively high or high-frequency voltages, and
a Zener diode (D1) mounted in opposition between the gate of (M1) and the drain and with a resistor (R3) and a diode (D2) in the forward direction in the drain-to-grid direction limit the switching speed of (M1), and
a circuit consisting of a Schottky diode (D4) mounted in opposition on the drain of (M1) and in series with a capacitor (C1) and a resistor (R1) connected to the positive terminal of the battery (4) to limit the overvoltage when opening (M1), in parallel on the Schottky diode (D4) a fixed resistor (11) is mounted connected on the one hand to the cathode of the diode and on the other hand to the drain of a second MOSFET (M2) whose source is connected to the anode of the Schottky diode (D4), the gate of (M2) being controlled by an output of the detection circuit to prevent the load.

22. Battery management system (BMS) (1) for accumulators according to claim 4, **characterized in that** the disconnection device (3) comprises a second switching device (31) in which
a first MOSFET (M1) connected by its source to the negative terminal of a set of single elements, the gate of this MOSFET (M1) is controlled by a voltage, this source delivering a voltage chosen so that (M1) is always on,
a circuit consisting of a Schottky diode (D4) mounted in opposition on the drain of (M1), in parallel on the Schottky diode (D4) a fixed resistor (11) is mounted connected on the one hand to the cathode of the Schottky diode (D4) and on the other hand to the drain of a second MOSFET (M2) whose source is connected to the anode of the Schottky diode (D4), the gate of (M2) being connected to the positive terminal of said set of single elements,
a Zener diode (D6) and a resistor (R6) in series with the gate of (M2), the Zener diode (D6) being mounted in the forward direction in the drain-gate direction, a Zener diode (D5) mounted in opposition between the gate and the source of (M2) to define, with the Zener diode (D6), the value of the voltage at the gate of (M2) and at which (M2) is on,
a capacitor C5) connected between the gate and the source of (M2) and in parallel with the Zener diode (D5) to protect the gate of (M2) from high-frequency voltages,
an optocoupler (OP1) mounted between the gate and the source of (M2) and in parallel with the capacitor (C5) to block (M2) in the event of the voltage or temperature of an element of the set of single elements being exceeded, the MOSFET (M2) then cutting off the charge current.
